Europäisches Patentamt

European Patent Office

Office européen des brevets

(19)

(11) EP 0 860 051 B1

(12) **EUROPÄISCHE PATENTSCHRIFT**

(45) Veröffentlichungstag und Bekanntmachung des Hinweises auf die Patenterteilung:
**08.09.1999 Patentblatt 1999/36**

(21) Anmeldenummer: **96938958.4**

(22) Anmeldetag: **01.10.1996**

(51) Int Cl.$^6$: **H03H 17/06**, H03H 17/02

(86) Internationale Anmeldenummer:
**PCT/DE96/01883**

(87) Internationale Veröffentlichungsnummer:
**WO 97/17758 (15.05.1997 Gazette 1997/21)**

(54) **SCHALTUNGSANORDNUNG UND VERFAHREN ZUR MEHRFACHNUTZUNG EINES DIGITALEN TRANSVERSALFILTERS**

CIRCUIT AND METHOD FOR THE MULTIPLE USE OF A DIGITAL TRANSVERSE FILTER

CIRCUIT ET PROCEDE POUR L'UTILISATION MULTIPLE D'UN FILTRE TRANSVERSAL NUMERIQUE

(84) Benannte Vertragsstaaten:
**DE FR GB**

(30) Priorität: **09.11.1995 DE 19541853**

(43) Veröffentlichungstag der Anmeldung:
**26.08.1998 Patentblatt 1998/35**

(73) Patentinhaber: **SIEMENS AKTIENGESELLSCHAFT 80333 München (DE)**

(72) Erfinder: **MEIER, Stefan D-81739 München (DE)**

(56) Entgegenhaltungen:
**EP-A- 0 500 394**

- **INTERNATIONAL SYMPOSIUM ON CIRCUITS AND SYSTEMS. (ISCAS) VLSI, LONDON, MAY 30 - JUNE 2, 1994, Bd. 4 OF 6, 30.Mai 1994, INSTITUTE OF ELECTRICAL AND ELECTRONICS ENGINEERS, Seiten 127-130, XP000493157 VAUPEL M ET AL: "HIGH-SPEED FIR-FILTER ARCHITECTURES WITH SCALABLE SAMPLE RATES"**
- **ELEKTRONIK, Bd. 40, Nr. 9, 30.April 1991, Seiten 54, 57-62, XP000228326 ISBANNER F: "VIDEOCODEC - VOLLSTAENDIG DIGITAL AUCH FILTER UND MATRIX/DEMATRIX IN DIGITALTECHNIK"**

**Beschreibung**

Für die hocheffiziente Realisierung von digitalen Transversalfiltern werden oftmals Bitplane- und Modified-Bitplane-Architekturen eingesetzt. Liegt die erforderliche äußere Datenrate (Abtastrate), bei der eine Filterfunktion ausgeführt werden soll, deutlich unter der internen Datenrate, mit der sich Filterschaltungen in modernen Schaltungstechnologien realisieren lassen, kann durch Konzepte zur Mehrfachnutzung des Transversalfilters eine Reduktion der Chipfläche bei einer gegebenen Durchsatzrate des Transversalfilters erreicht werden.

Bei der Mehrfachnutzung des Transversalfilters werden in einem Rechenwerk während eines äußeren Taktes mehrere Teilrechenschritte in mehreren internen Takten nacheinander ausgeführt. Dabei muß besonders darauf geachtet werden, daß der zusätzliche Aufwand für das sequentielle Zuführen der Operanden für die Teilrechenschritte und das Speichern von Zwischenergebnissen nicht zu groß wird.

Grundlagen zur Realisierung von digitalen Transversalfiltern in Bitplane- und Modified-Bitplane-Architekturen sind bekannt und in (T. Noll, Carry-Save Architectures for High-Speed Digital Signal Processing, Journal of VLSI Signal Processing, Vol. 3, Kluwer Academic Publishers, Boston, S. 121 - 140, 1991) beschrieben.

Bei Schaltungsanordnungen, bei denen die erforderliche äußere Datenrate, bei der eine Transversalfilter-Funktion ausgeführt werden soll, höher als die interne Datenrate, mit der sich Transveralfilter-Schaltungen realisieren lassen, können linear skalierende Parallelisierungskonzepte eingesetzt werden, die bekannt sind (U. Seuben et al, Digitale Filter für Videosignale, Design und Elektronik, No. 9, Seite 69, 1991).

Die Zusammenschaltungen mehrerer Teilfilter zu einem komplexwertigen Filter sind beispielsweise beschrieben in (S. Quereshi, Adaptive Equalization, Proc. of the IEEE, Vol. 73, No. 9, S. 1349 bis 1387, 1985).

Aus (M. Vaopel und H. Meyr, High Speed FIR-Filter Architectures with Scalable Rates, Internat. Symposium on Circuits and System (ISCAS) VLSI, London, May 40 - June 2, Band 4, 30. May 1994) sind Grundlagen über Hochgeschwindigkeins-FIR-Filterarchitekturen bekannt (FIR = Finit Impulse Response).

Der Erfindung liegt das Problem zugrunde, eine Schaltungsanordnung und ein Verfahren anzugeben, mit der bzw. mit dem eine Mehrfachnutzung eines digitalen Transversalfilters möglich ist.

Das Problem wird durch die Schaltungsanordnung gemäß Patentanspruch 1, durch die Schaltungsanordnung gemäß Patentanspruch 4, durch die Schaltungsanordnung gemäß Patentanspruch 5, durch die Schaltungsanordnung gemäß Patentanspruch 6, durch das Verfahren gemäß Patentanspruch 12 sowie durch das Verfahren gemäß Patentanspruch 16 gelöst.

Durch die Schaltungsanordnung gemäß Patentanspruch 1 ist eine Mehrfachnutzung eines digitalen Transversalfilters möglich, wenn die innere Datenrate des digitalen Filters um ein ganzzahliges Vielfacheres höher ist als die erforderliche äußere Datenrate, mit der der digitale Transversalfilter Daten "filtern" muß.

Dadurch, daß jeweils zwei Multiplizierereinheiten für die Multiplikation eines Koeffizienten mit einem Eingangsdatenwort vorgesehen sind, und in den Multipliziererzellen jeweils in einem äußeren Takt mehrere Koeffizientenbits mit dem jeweils anliegenden Eingangsdatenwort multipliziert werden, wird eine Reduktion der erforderlichen Chipfläche bei der Realisierung des digitalen Transversalfilters erreicht.

In weiteren Varianten von Ausführungsbeispielen sind ebenso zwei Multipliziererzellen für jedes Koeffizientenwort vorgesehen, in denen allerdings jeweils das gesamte Koefffzientenwort mit jeweils einem Bit des Eingangsworts multipliziert wird.

Weiterbildungen der Erfindung ergeben sich aus den abhängigen Ansprüchen.

In den Figuren sind mehrere bevorzugte Ausführungsbeispiele dargestellt, die im folgenden näher beschrieben werden.

Es zeigen

Figur 1 einen Ausschnitt einer Schaltungsanordnung eines digitalen Transversalfilters mit drei Abgriffen (Taps), das zur Mehrfachnutzung in Richtung der Koeffizientenwortbreite eingesetzt wird;

Figur 2 einen Ausschnitt einer Schaltungsanordnung, die eine weitere Möglichkeit zur Realisierung eines zur Mehrfachnutzung in Richtung der Koeffizientenwortbreite geeigneten digitalen Transversalfilters darstellt;

Figur 3 einen Ausschnitt einer Schaltungsanordnung, die ein drittes Ausführungsbeispiel eines digitalen Transversalfilters beschreibt, das zur Mehrfachnutzung in Richtung der Koeffizientenwortbreite geeignet ist;

Figur 4 einen Ausschnitt einer Schaltungsanordnung, die ein Ausführungsbeispiel eines digitalen Transversalfilters beschreibt, das zur Mehrfachnutzung in Richtung der Eingangswortbreite geeignet ist;

Figur 5 einen Ausschnitt einer Schaltungsanordnung, die ein weiteres Ausführungsbeispiel eines digitalen Transversalfilters beschreibt, das zur Mehrfachnutzung in Richtung der Eingangswortbreite geeignet ist, bei dem mehrere Teiloperationen von zwei Teilfiltern eines komplexwertigen Filters nacheinander ausgeführt werden;

Figur 6 ein Prinzipschaltbild eines Interpolations-

| Figur 7 | ein Prinzipschaltbild eines Dezimierungsfilters in Polyphasenstruktur; |
|---|---|
| Figur 8 | ein Prinzipschaltbild einer Anordnung eines komplexwertigen Filters; |
| Figur 9 | eine Schaltungsanordnung, bei dem die Mehrfachnutzung des digitalen Transversalfilters sich nicht nur auf die einzelnen Koeffizientenbits des Transversalfilters bezieht, sondern auf die einzelnen Teilfilter des gesamten, in Figur 6 beschriebenen digitalen Interpolationsfilters in Polyphasenstruktur; |
| Figur 10 | eine Schaltungsanordnung, in der die Mehrfachnutzung nicht nur für die einzelnen Koeffizientenbit des digitalen Transversalfilters genutzt wird, sondern zusätzlich zur Mehrfachnutzung von Teilfiltern eines Gesamtfilters zur Realisierung eines Dezimierungsfilters in Polyphasenstruktur, wie es in Figur 7 beschrieben ist; |
| Figur 11 | ein Ablaufdiagramm, das die Verfahrensschritte des Verfahrens zur Mehrfachnutzung eines digitalen Transversalfilters in Richtung der Koeffizientenwortbreite beschreibt; |
| Figur 12 | ein Ablaufdiagramm, das die Verfahrensschritte des Verfahrens zur Mehrfachnutzung eines digitalen Transversalfilters in Eingangswortbreite beschreibt; |
| Figur 13 | eine Skizze, in der verschiedene Möglichkeiten zur Summation bei der Mehrfachnutzung eines digitalen Transversalfilters in Richtung der Koeffizientenwortbreite dargestellt sind. |

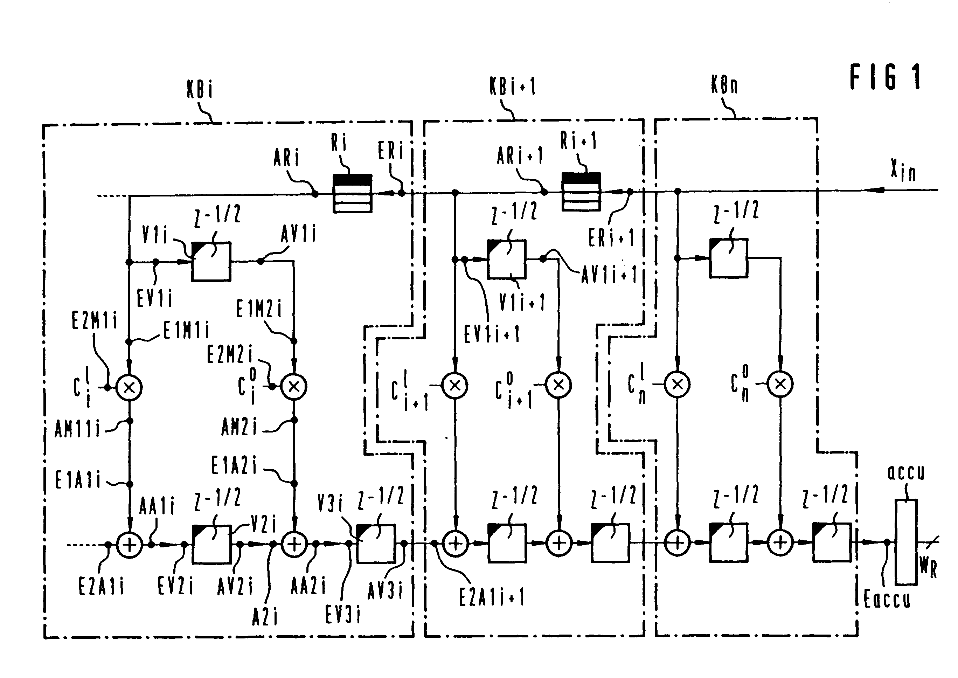

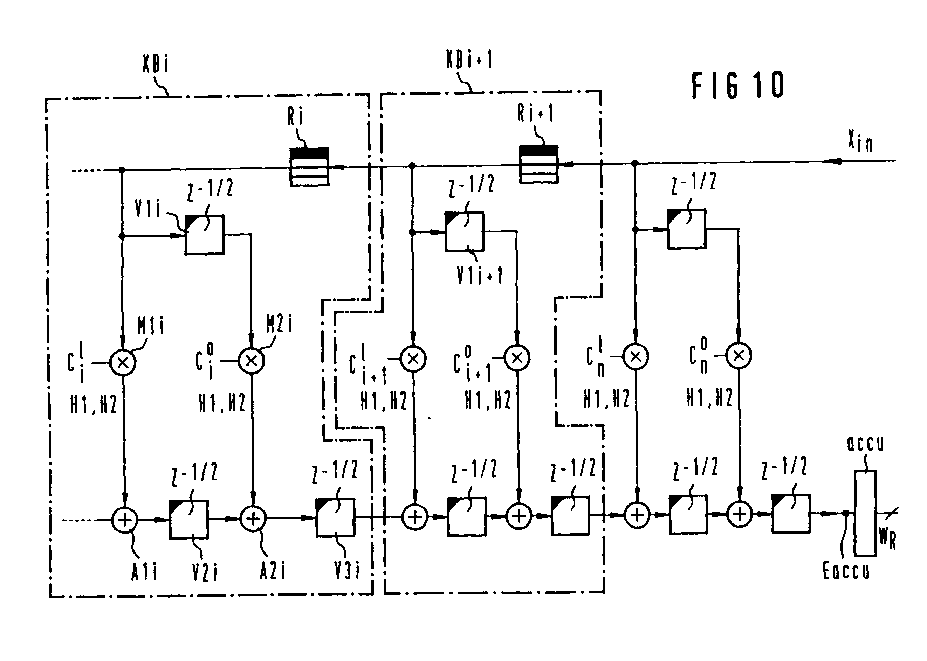

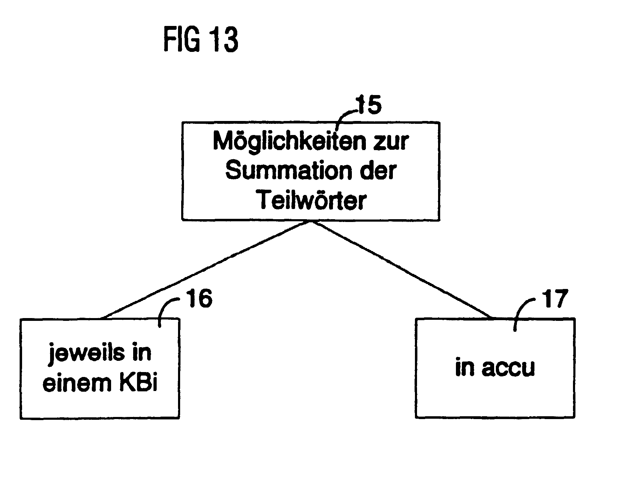

Anhand der Figuren 1 bis 13 werden die erfindungsgemäßen Schaltungsanordnungen und die erfindungsgemäßen Verfahren weiter erläutert.

In Figur 1 ist eine Schaltungsanordnung eines ersten Ausführungsbeispiels eines digitalen Transversalfilters F beschrieben. Obwohl in dieser Figur nur ein Ausschnitt von drei Abgriffen (Taps) eines digitalen Transversalfilters F dargestellt ist, beschränkt sich diese hier dargestellte erfindungsgemäße Schaltungsanordnung selbstverständlich nicht auf einen digitalen Transversalfilter mit drei Koeffizienten, sondern kann, für jeden Fachmann ohne weiteres ersichtlich, auf einen digitalen Transversalfilter mit n Koeffizienten erweitert werden, wobei n eine beliebige natürliche Zahl ist.

Im weiteren werden mit dem Begriff "das Filter" die Schaltungsanordnungen des Filters bezeichnet, mit denen sich Filter-Schaltungen realisieren lassen, und mit dem Begriff "oder Filter" wird die Übertragungsfunktion zur Beschreibung der Filterstruktur bezeichnet.

Der digitale Transversalfilter F, der für n Koeffizienten realisiert wird, in Figur 1 ist also die Anzahl der Koeffizienten n = 3, ist in n Koeffizientenblöcke KBi aufgeteilt.

Der Index i bezeichnet jeden Koeffizientenblock KBi eindeutig. Er ist eine natürliche Zahl im Bereich von 1 bis n.

Jeder Koeffizientenblock KBi weist mindestens folgende Komponenten auf:

-    eine erste Multiplizierereinheit M1i,
-    eine zweite Multiplizierereinheit M2i,
-    eine erste Addiereinheit A1i,
-    eine zweite Addiereinheit A2i,
-    eine erste Verzögerungseinheit V1i,
-    eine zweite Verzögerungseinheit V2i,
-    eine dritte Verzögerungseinheit V3i, und
-    eine Registereinheit Ri.

Außerdem weist die Schaltungsanordnung des digitalen Transversalfilters F zusätzlich eine Gesamtaddiereinheit accu auf.

Für die weiteren Ausführungen getroffene eine Annahme, daß die beschriebene Schaltungsanordnung drei Abgriffe (Taps) aufweist, schränken die Allgemeingültigkeit des Verfahrens sowie der Anordnung nicht ein.

Für jeden Fachmann ist es ohne weiteres ersichtlich, daß diese getroffene Annahme nur zur Verdeutlichung des Prinzips, auf dem die verschiedenen Ausführungsbeispiele der erfindungsgemäßen Schaltungsanordnungen beruhen, dienen.

Wie im vorigen erläutert, ist in Figur 1 ein Ausschnitt des digitalen Transversalfilters F mit drei Abgriffen (Taps) dargestellt.

Jeder Koeffizientenblock KBi weist in diesem ersten Ausführungsbeispiel folgenden Aufbau auf. Die erste Addiereinheit A1i ist über einen ersten Eingang EIA1i der ersten Addiereinheit A1i mit einem Ausgang AM1i der ersten Multiplizierereinheit M1i gekoppelt.

Weiterhin ist die zweite Addiereinheit A2i über einen ersten Eingang E1A2i mit einem Ausgang AM2i der zweiten Multiplizierereinheit M2i gekoppelt.

Die erste Verzögerungseinheit V1i ist über ihren Eingang EV1i mit einem ersten Eingang E1M1i der ersten Multiplizierereinheit M1i gekoppelt. Ein Ausgang AV1i der ersten Verzögerungseinheit V1i ist mit einem ersten Eingang E1M2i der zweiten Multiplizierereinheit M2i gekoppelt.

Die zweite Verzögerungseinheit V2i ist über ihren Eingang EV2i mit einem Ausgang AA1i der ersten Addiereinheit A1i und über ihren Ausgang AV2i mit einem zweiten Eingang E2A2i der zweiten Addiereinheit A2i gekoppelt.

An einen zweiten Eingang E2M1i der ersten Multiplizierereinheit M1i werden nacheinander auf eine im weiteren beschriebene Art und Weise Koeffizientenbits $c_i^j$ nacheinander angelegt.

Hierbei bezeichnet wie im vorigen der Index i den Koeffizienten eindeutig, für den der jeweilige Koeffizientenblock KBi vorgesehen ist.

Ein weiterer Index 1, der eine natürliche gerade Zahl ist, also im Bereich 0, 2, 4, 6, ..., $w_k$-2 liegt, wobei eine Koeffizientenwortbreite $w_k$ die Lange des jeweiligen Koeffizientenworts $c_i$ in binärer Schreibweise angibt. Es werden also an den zweiten Eingang E2M1i der ersten Multiplizierereinheit M1i nacheinander die einzelnen Koeffizientenbits $c_i^l$ angelegt mit der Wertigkeit $2^0$, $2^2$, $2^4$, $2^6$, ..., $2^{w_k-2}$.

An einen zweiten Eingang E2M2i der zweiten Multiplizierereinheit M2i werden Koeffizientenbits $c_i^o$ ungerader Wertigkeit angelegt. Der Index o ist eine ungerade natürliche Zahl, also eine Zahl aus 1, 3, 5, 7, ..., $w_k$-1. Es werden also an den zweiten Eingang E2M2i der zweiten Multiplizierereinheit M2i nacheinander die Koeffizienten $c_i^o$ bits angelegt mit der Wertigkeit $2^1$, $2^3$, $2^5$, $2^7$, ..., $2^{w_k-1}$.

Weiterhin weist jeder Koeffizientenblock KBi eine Registereinheit Ri auf, die über ihren Ausgang ARi mit dem ersten Eingang E1m1i der ersten Multiplizierereinheit M1i und dem Eingang EV1i der ersten Verzögerungseinheit V1i gekoppelt ist.

Die einzelnen Koeffizientenblöcke KBi sind in der Weise miteinander verbunden, daß jeweils ein Eingang ERi der Registereinhheit Ri das i-ten Koeffizientenblocks KBi mit einem Ausgang ARi+1 einer Registereinheit Ri+1 eines folgenden Koeffizientenblocks KBi+1 gekoppelt ist.

Außerdem ist ein Ausgang AV3i der dritten Verzögerungseinheit V3i mit einem zweiten Eingang E2A1i+1 einer ersten Addiereinheit A1i+1 des folgenden Koeffizientenblocks KBi+1 gekoppelt.

Jeder der n Koeffizientenblöcke KBi weist den gleichen im vorigen beschriebenen Aufbau auf und ist ebenso wie im vorigen beschrieben mit den jeweiligen Nachbarkoeffizientenblöcken gekoppelt.

Außerdem ist die Gesamtaddiereinheit accu vorgesehen, deren Eingang Eaccu mit einem Ausgang AV3n einer dritten Verzögerungseinheit V3n des n-ten Koeffizientenblocks KBn gekoppelt ist.

In der Gesamtaddiereinheit accu werden alle Teilwörter, die jeweils von den Koeffizientenblöcken KBi, wie im weiteren beschrieben wird, "weitergereicht" werden, entsprechend der bekannten Wertigkeit der einzelnen Teilwörter aufsummiert.

Es wird angenommen, daß pro äußerem Takt der digitale Transversalfilter F $w_{k/2}$ innere Takte durchführt. Somit weist der digitale Transversalfilter F eine um das $w_{k/2}$-fache niedrigere Datenrate auf als sie an und für sich von dem digitalen Transversalfilter F "benötigt" wird.

Die Registereinheit Ri jedes Koeffizientenblocks KBi weist in einer Variante der erfindungsgemäßen Schaltungsanordnung ein Register auf, und in einer weiteren Variante $w_{k/2}$-1 Register auf. Die unterschiedliche Anzahl der Register, die die Registereinheit Ri aufweist, hat Auswirkungen auf die unterschiedliche Verweildauer der jeweiligen Eingangsdatenwörter $x_{in}$, mit denen die einzelnen Koeffizientenbits der jeweiligen Koeffizienten $c_i$ multipliziert werden.

Dies bedeutet, wenn die Registereinheit Ri genau ein Register aufweist, wird dieses Register, das jeweils genau das Eingangsdatenwort $x_{in}$ speichert, jeweils nach $w_{k/2}$ inneren Takten mit einem neuen Eingangsdatenwort $x_{in}^{'}$ geladen. Dies bedeutet bei einer Aneinanderkettung der Registereinheiten Ri, wie sie in Figur 1 dargestellt sind, das die jeweiligen Eingangsdatenworte $x_{in}$, $x_{in}^{'}$, etc. von Registereinheit zu Registereinheit "weitergereicht" werden. Die Ansteuerung der einzelnen Register muß mit einer Verzögerung von $w_{k/2}$-1 inneren Takten erfolgen.

In einem Koeffizientenblock KBi wird also das für $w_{k/2}$ innere Takte lang in der Registereinheit Ri gespeicherte Eingangsdatenwort $x_{in}$ jeweils nacheinander mit jeweils einem Koeffizientenbit $c_i^l$ gerader Wertigkeit, und um einen halben inneren Takt verzögert, mit einem Koeffizientenbit $c_i^o$ ungerader Wertigkeit in der zweiten Multiplizierereinheit M2i multipliziert.

Die einzelnen Teilergebnisse, werden, wie in der Figur 1 dargestellt, jeweils in jeder Verzögerungseinheit V1i, V2i, V3i um einen halben inneren Takt verzögert und entsprechend der Schaltungsanordnung "weitergereicht" bis zu dem n-ten Koeffizientenblock KBn, wo sie dann in der Gesamtaddiereinheit accu zu einem Ergebniswort $w_R$ aufsummiert werden.

Weist die Registereinheit Ri $w_{k/2}$-1 Register auf, so ist zwar die Anzahl der benötigten Register erhöht, jedoch ist die Ansteuerung der Register zur "Verwaltung" der Eingangsdatenworte $x_{in}$, $x_{in}^{'}$, etc. einfacher, da in diesem Fall jedes Eingangsdatenwort $x_{in}$, $x_{in}^{'}$, etc. genau $w_k$-mal hintereinander in die Registereinheit Ri geschrieben wird, und mit jedem inneren Takt weitergereicht wird. Der weitere, im obigen beschriebene Verlauf des Verfahrens ändert sich durch die unterschiedliche Anzahl der Register, die die Registereinheit Ri aufweist, nicht.

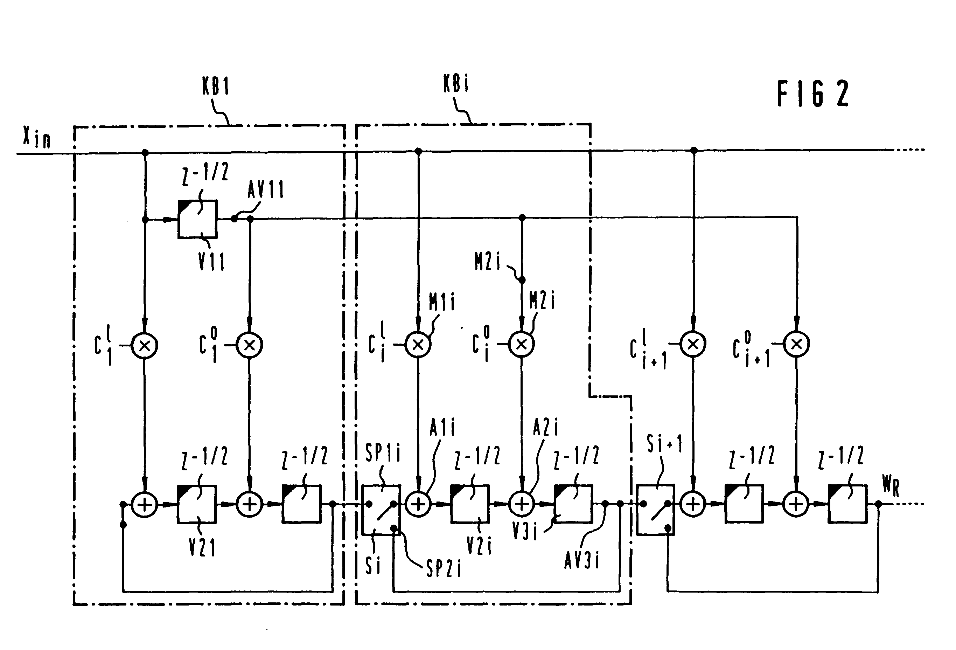

Ein weiteres Ausführungsbeispiel einer Schaltungsanordnung zur Mehrfachnutzung des Filters F in Richtung der Koeffizientenwortbreite ist in Figur 2 dargestellt und wird im folgenden beschrieben.

Der Koeffizientenblock KBi unterscheidet sich von dem in Figur 1 dargestellten Ausführungsbeispiel insoweit, daß nur für den ersten Koeffizientenblock KB1 die erste Verzögerungseinheit V11 vorgesehen ist. Bei den restlichen Koeffizientenblöcken KBi, i ≠ 1, ist jeweils der erste Eingang E1M2i der zweiten Multiplizierereinheit M2i mit dem Ausgang AV11 der ersten Verzögerungseinheit V11 des ersten Koeffizientenblocks KB1 gekoppelt.

Weitere erste Verzögerungseinheiten V1i sind in diesem Ausführungsbeispiel nicht vorgesehen.

Weiterhin unterscheidet sich das in Figur 2 beschriebene Ausführungsbeispiel von den in Figur 1 beschriebenen darin, daß keine Registereinheiten Ri vorgesehen sind.

Dafür ist in jedem Koeffizientenblock KBi eine koeffizientenblock-interne Rückkopplung vorgesehen.

Dies bedeutet, daß eine zusätzliche Schaltereinheit Si vorgesehen ist, die eine erste Schalterposition SP1i und eine zweite Schalterposition SP2i aufweist.

Bei einer ersten Schalterposition SP1i ist der i-te Koeffizientenblock KBi, genauer gesagt der zweite Eingang E2A1i der ersten Addiereinheit A1i des i-ten Koeffizientenblocks KBi mit dem Ausgang AV3i-1 der dritten Verzögerungseinheit V3i-1 eines vorangegangenen Koeffizientenblocks KBi-1 gekoppelt. In der zweiten Schalterposition SP2i ist der i-te Koeffizientenblock KBi mit dem "eigenen" Ausgang AV3i der dritten Verzögerungseinheit V3i desselben Koeffizientenblocks KBi gekoppelt.

Wenn die Schaltereinheit Si genau solange in der ersten Schalterposition SP1i ist, die benötigt wird zur Multiplikation des gesamten Koeffizienten $c_i$, d. h. zur Multiplikation aller einzelnen Koeffizientenbits $c_i^l$, $c_i^o$ des jeweiligen Koeffizientenblocks KBi, so entspricht die "Rückkopplung" einer koeffizientenblock-internen Summation der Teilergebnisse der Multiplikationen des jeweiligen Koeffizientenbits $c_i^l$, $c_i^o$ mit dem Eingangswort $x_{in}$.

Da in diesem Ausführungsbeispiel die Summation jeweils in den einzelnen Koeffizientenblöcken KBi stattfindet, ist es leicht ersichtlich, daß in diesem Fall keine Gesamtaddiereinheit accu benötigt wird und daher auch nicht vorgesehen ist.

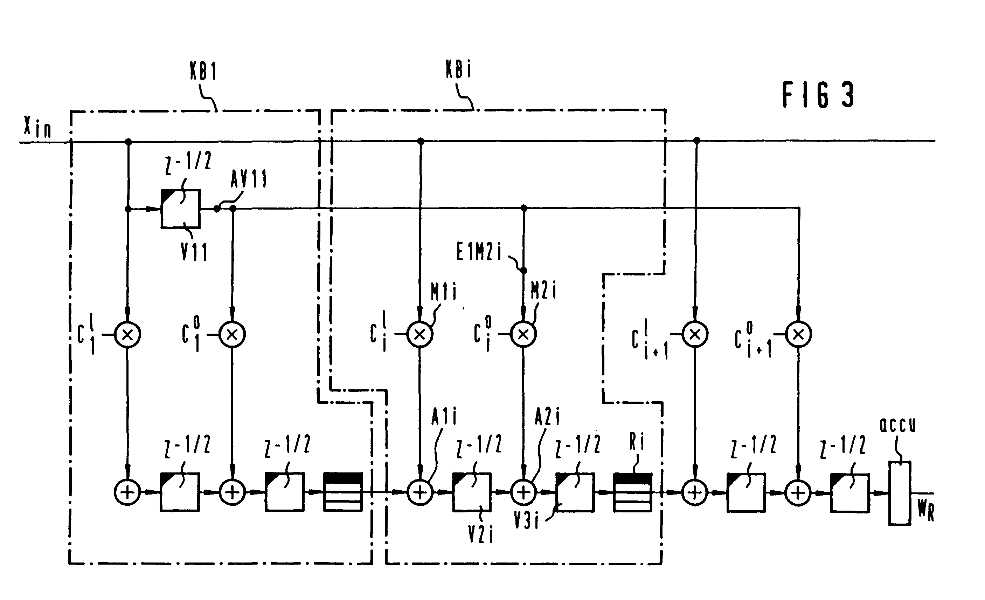

Ein drittes Ausführungsbeispiel ist in Figur 3 angegeben.

In diesem Ausführungsbeispiel weist wiederum, wie in dem in Figur 2 dargestellten Ausführungsbeispiel nur der erste Koeffizientenblock KB1 die erste Verzögerungseinheit V11 auf. Alle restlichen Koeffizientenblöcke KBi, i ≠ 1, weisen keine erste Verzögerungseinheit V1i auf, sondern es sind jeweils die ersten Eingänge E1M2i der zweiten Multiplizierereinheit M2i mit dem Ausgang AV11 der ersten Verzögerungseinheit V11 des ersten Koeffizientenblocks KB1 gekoppelt.

Im Unterschied zu dem in Figur 2 dargestellten dritten Ausführungsbeispiel, ist keine Schaltereinheit Si vorgesehen, da in diesem Ausführungsbeispiel die einzelnen Teilergebnisse wieder "weitergereicht" werden von Koeffizientenblock zu Koeffizientenblock, und schließlich in der Gesamtaddiereinheit accu zu dem Ergebniswort $w_R$ aufsummiert werden.

Es sind Registereinheiten Ri vorgesehen, die allerdings jeweils mit ihren Eingängen ERi mit den Ausgängen AV3i der dritten Verzögerungseinheiten V3i gekoppelt sind, und deren Ausgänge ARi jeweils mit den zweiten Eingängen E2A1i+1 der ersten Addiereinheiten A1i+1 der jeweils folgenden Koeffizientenblöcke KBi+1 gekoppelt sind. Die Registereinheiten Ri weisen $w_{k/2}-1$ Register auf.

Wird eine Carry-Save-Addition durchgeführt, so ist eine doppelte Anzahl an Registern in jeder Registereinheit Ri vorgesehen, also $w_k * 2$ Register, ein Teil für das Übertrags-Wort und einen Teil für das Summenwort. Die Anzahl der Verzögerungen ändert sich in diesem Fall nicht. Bei Anwendung einer Carry-Save-Addition ist in der Gesamtaddiereinheit accu zur korrekten Durchführung der Addition eine Vector-Merging-Adder-Funktionalität vorzusehen.

Die Ansteuerung der einzelnen Multipliziereinheiten mit den einzelnen Koeffizientenbits $c_i^l$, $c_i^o$ und die Ansteuerung der Registereinheiten Ri ergibt sich aus den im vorigen dargestellten Überlegungen sowie aus der Figur 3.

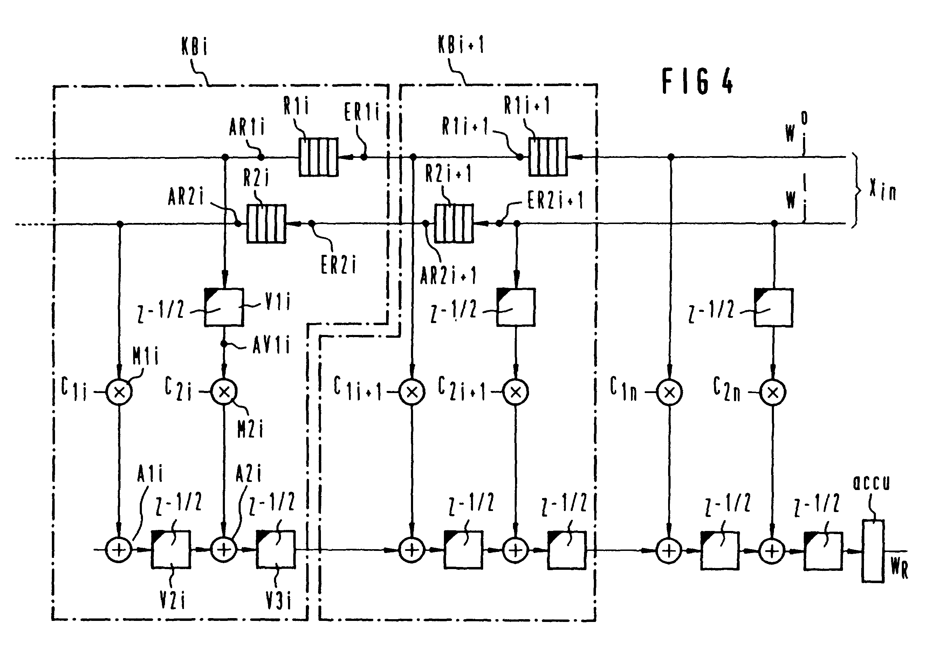

In Figur 4 ist eine Schaltungsanordnung zur Mehrfachnutzung des Filters F in Richtung einer Eingangsdatenwortbreite $w_m$ der Eingangsdatenworte $x_{in}$ dargestellt.

Ein Index j identifiziert jedes Eingangsdatenwortbit $w_j$ eindeutig und ist eine beliebige Zahl im Bereich von 1 bis m, wobei eine Zahl m die Wortbreite des Eingangsdatenwortes $x_{in}$ angibt.

Anstatt der Registereinheit Ri sind bei dieser Schaltungsanordnung eine erste Registereinheit R1i und eine zweite Registereinheit R2i vorgesehen.

Hierbei ist ein Ausgang AR1i der ersten Registereinheit R1i mit dem Eingang EV1i der ersten Verzögerungseinheit V1i gekoppelt. Ein Eingang ER1i der ersten Registereinheit R1i ist mit einem Ausgang AR1i+1 einer ersten Registereinheit R1i eines folgenden Koeffizientenblocks KBi+1 gekoppelt.

Ein Ausgang AR2i der zweiten Registereinheit R2i ist mit einem ersten Eingang E1M1i der ersten Multipliziereinheit M1i gekoppelt. Ein Eingang ER2i der zweiten Registereinheit R2i ist mit einem Ausgang AR2i+1 einer zweiten Registereinheit R2i eines folgenden Koeffizientenblocks KBi+1 gekoppelt.

Die erste Registereinheit R1i und die zweite Registereinheit R2i weisen jeweils $\frac{w_j}{2}$ - 1 Register mit einer Wortbreite von mindestens einem Bit auf.

In dieser in Figur 4 dargestellten Schaltunganordnung ist wiederum die Gesamtaddiereinheit accu vorgesehen, die über ihren Eingang Eaccu mit dem Ausgang AV3n der dritten Verzögerungseinheit V3n des n-ten Koeffizientenblocks KBn gekoppelt ist.

In diesem Fall ist die innere Taktrate um das $\frac{w_j}{2}$-fache größer als die "benötigte" äußere Taktrate des Filters F.

An den zweiten Eingang E2M1i der ersten Multipliziererzelle M1i und an den zweiten Eingang E2M2i der zweiten Multipliziererzelle M2i wird jeweils der gesamte Koeffizient $c_i$ des i-ten Koeffizientenblocks KBi angelegt. Somit wird in der ersten Multipliziererzelle M1i der gesamte Koeffizient $c_i$ des i-ten Koeffizientenblocks KBi mit jeweils einem Eingangswortbit $w_j^o$ ungerader Wertigkeit multipliziert. In der zweiten Multipliziererzelle M2i wird der gesamte Koeffizient $c_i$ des i-ten Koeffizientenblocks KBi mit jeweils einem Eingangswortbit $w_j^l$ gerader Wertigkeit multipliziert.

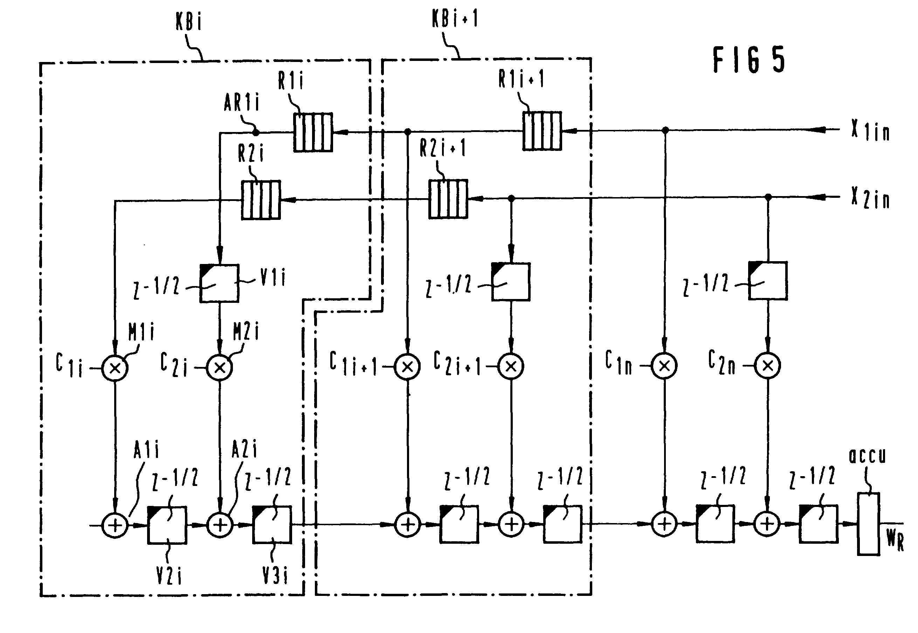

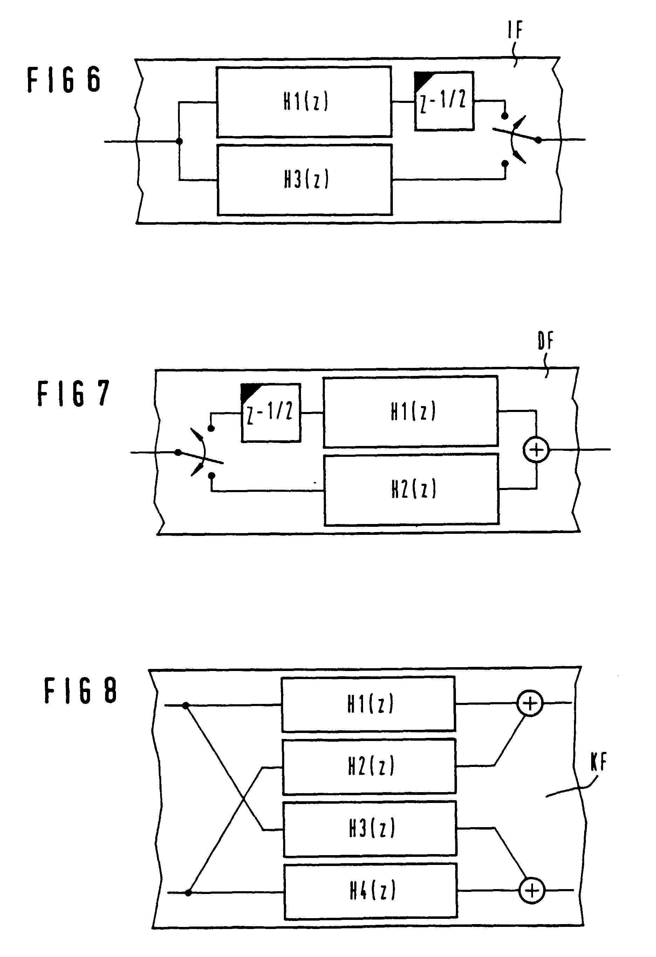

In Figur 5 ist eine Schaltungsanordnung des Filters F dargestellt zur Realisierung eines in Figur 8 abstrakt dargestellten komplexwertigen Filters, bei der im Unterschied zu der in Figur 4 dargestellten Schaltungsanordnung an den zweiten Eingang E2M1i der ersten Multipliziererzelle M1i und an den zweiten Eingang E2M2i der zweiten Multipliziererzelle M2i jeweils für $w_m$ innere Takte lang Koeffizienten von im weiteren beschriebenen Teilfilterfunktionen Hr(z) werden.

In diesem Fall werden in die erste Registereinheit R1i Bits eines ersten Eingangswortes $x_{1in}$, das mit einer ersten Teilfilterfunktion H1(z) gefiltert wird, bitseriell "eingeschoben". Somit werden die einzelnen Bits des ersten Eingangswortes $x_{1in}$ mit den Koeffizienten $c_{1i}$ der ersten Teilfilterfunktion H1(z) multipliziert.

In die zweite Registereinheit R2i werden in diesem Fall Bits eines zweiten Eingangswortes $x_{2in}$, das mit einer zweiten Teilfilterfunktion H2(z) gefiltert wird, bitseriell "eingeschoben". Somit werden die einzelnen Bits des zweiten Eingangswortes $x_{2in}$ mit den Koeffizienten $c_{2i}$ der zweiten Teilfilterfunktion H2(z) multipliziert.

Beide Registereinheiten weisen jeweils $w_m$-1 Register mit mindestens einer Wortbreite von einem Bit auf.

In den Figuren 6 bis 8 sind unterschiedliche Anordnungen zur Verwendung der erfindungsgemäßen Schaltungsanordnungen nicht nur für die Koeffizienten einer Filterfunktion, sondern zusätzlich auch für mehrere unterschiedliche Filterfunktionen, d. h. für die Koeffizienten unterschiedlicher Teilfilterfunktionen Hr(z), wobei die Teilfilterfunktionen Hr(z) durch einen Index r, der eine natüR1iche Zahl im Bereich von 1 bis s ist, eindeutig identifiziert werden.

Dieser Fall tritt dann auf, wenn nicht nur ein, sondern mehrere Transversalfilter zusammen realisiert werden.

Dies sind beispielsweise Filterbänke, Polyphasenfilter, z. B. als Interpolationsfilter (vgl. Figur 6) oder Dezimierungsfilter (vgl. Figur 7) oder die Zusammenschaltung von beispielsweise vier Filtern zu einem komplexwertigen Filter (vgl. Figur 8).

Diese in den Figuren dargestellten Möglichkeiten zur Zusammenschaltung mehrerer Transversalfilter und der damit verbundenen möglichen Mehrfachnutzungen der erfindungsgemäßen Schaltungsanordnungen sind selbstverständlich nicht auf die in den Figuren dargestellten Fälle für z. B. die Zusammenschaltung nur zweier Filterfunktionen beschränkt.

Diese Fälle sind für den Fachmann, sofort ersichtlich, jederzeit auf beliebige Dimensionen erweiterbar, wobei bei der Erweiterung die Zahl der Teilfilter, multipliziert mit $\frac{w_k}{2}$, gleich ist dem Verhältnis $\frac{innerer\,Takt}{äußerer\,Takt}$.

Die Grundlagen zur Zusammenschaltung mehrerer Transversalfilter ist z. B. in (S. Quereshi, Adaptive Equalization, Proc. of the IEEE, Vol. 73, No. 9, S. 1349 bis 1387, 1985) beschrieben.

Man kann dabei nicht nur mehrere Teilfilteroperationen auf der gleichen Hardware ausführen, also mit derselben erfindungsgemäßen Schaltungsanordnung, sondern in den vorgenannten Fällen kann man sich zunutze machen, daß zwei oder auch mehr Teilfilterfunktionen Hr(z), die entweder mit den gleichen Eingangsdaten arbeiten, oder deren Ergebnisse aufaddiert werden, auf der gleichen Hardware nacheinander berechnet werden. Die Art der Zusammenschaltung mit jeweils einer Verzögerungseinheit, die die anliegenden Daten jeweils um einen halben inneren Takt verzögert, sind in den Figuren 4 und 5 beschrieben und daraus ersichtlich.

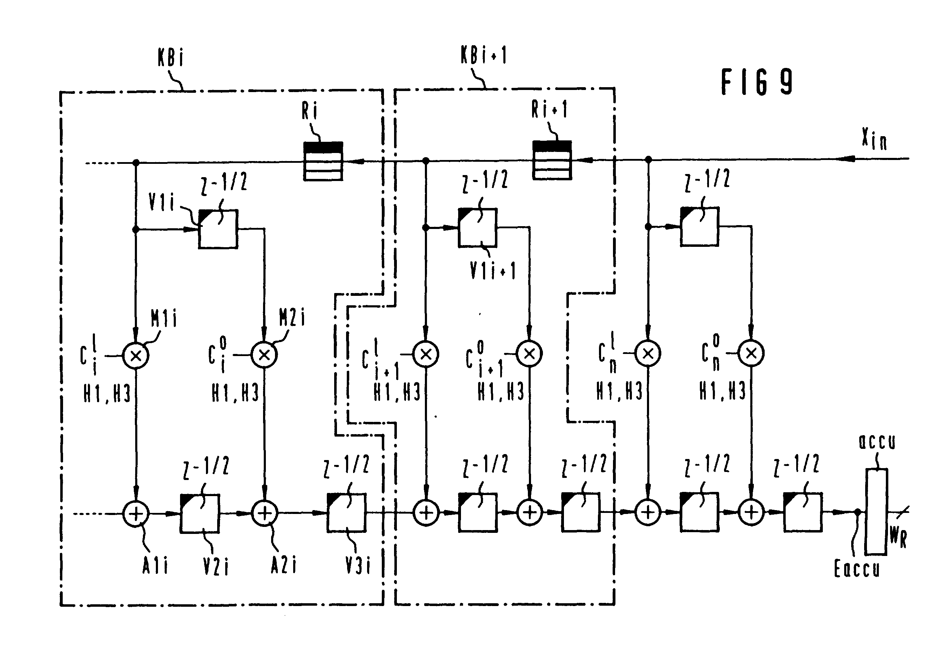

Bei der in Figur 6 beschriebenen Schaltungsanordnung werden beispielsweise zwei Teilfilter H1(Z) und H3(Z) eines Interpolationsfilters in Polyphasenstruktur nacheinander in $w_k$ inneren Taktschritten auf der in Figur 9 dargestellten Schaltungsanordnung berechnet.

In diesem Fall muß die Ansteuerung der Verzögerungseinheiten der Eingänge gegenüber der in Figur 1 dargestellten Schaltungsanordnung so abgeändert werden, daß alle $w_k$ inneren Takte Daten übernommen werden und die Übernahme der Daten von Koeffizientenblock zu Koeffizientenblock um $w_k$-1 innere Takte verzögert wird. Die Koeffizientenbits $c_i$ werden, wie bisher beschrieben, ebenso in den Reihenfolgen der Wertigkeiten 0, 2, 4, ... bzw. 1, 3, 5, ... angelegt, in diesem Fall aber zuerst für die Koeffizienten einer der beiden Teilfilter-Übertragungsfunktionen H1(z) und H3(z) und danach für die Koeffizienten der jeweils anderen Übertragungsfunktion.

Die Gesamtaddiereinheit accu muß nach wie vor über $w_{k/2}$ Teilergebnisse aufsummieren und liefert alle $w_{k/2}$ inneren Takte abwechselnd jeweils ein Ergebnis für jeweils eines der Teilfilter H1(z) bzw. H3(z).

Bei Polyphasenfiltern mit r Teilfilter, mit gemeinsamen Dateneingängen lassen sich Mehrfachnutzungsfaktoren von $r * w_{k/2}$ realisieren, wenn man die Eingangsdaten alle $r * w_{k/2}$, und dabei um $r * w_{k/2}$-1 innere Takte verzögert von Koeffizientenblock zu Koeffizientenblock übernimmt. Die Gesamtaddiereinheit accu liefert dann r Teilergebnisse nacheinander jeweils für einen der r Teilfilter Hr(z).

Für die Realisierung eines komplexwertigen Filters kann man die beiden Teilfilter-Übertragungsfunktionen H1(Z) und H3(Z) in der gleichen Weise auf die in Figur 8 beschriebenen Architektur anwenden, wie bei dem in Figur 6 dargestellten Polyphasenfilter mit zwei Teilfiltern.

Bei der Realisierung z. B. zweier Teilfilter eines Dezimierungsfilters in Polyphasenstruktur nacheinander in $w_k$ inneren Taktschritten, wie sie in Figur 7 dargestellt ist, gerechnet, sind gegenüber der in Figur 1 beschriebenen Architektur anstatt eines Verzögerungsregisters, also anstatt der Registereinheit Ri, für die Eingangsdaten zwei Register für die Eingangsdaten pro Abgriff, also pro Tap vorgesehen.

Dabei wird jeweils $w_{k/2}$ innere Takte lang ein Eingangswort des einen und dann $w_{k/2}$ innere Takte lang ein Eingangswort des anderen Teilfilters angelegt. Die Register übernehmen alle $w_{k/2}$ innere Takte Daten. Die Datenübernahme ist von Abgriff zu Abgriff um $w_k$-1 innere Takte verzögert.

Bei Polyphasenfiltern mit r Teilfiltern mit getrennten Dateneingängen lassen sich somit Mehrfachnutzungsfaktoren von $r * w_{k/2}$ realisieren, wenn man die Eingangsdaten durch r Register von Abgriff zu Abgriff verzögert, wobei die Register alle $w_{k/2}$ innere Takte Daten übernehmen, und die Übernahme von Koeffizientenblock zu Koeffizientenblock um $r * w_{k/2}-1$ innere Takte verzögert ist.

Die Gesamtaddiereinheit accu liefert dann je nach Ansteuerung entweder alle $w_{k/2}$ inneren Takte ein Teilergebnis oder nach jeweils $r * w_{k/2}$ inneren Takte die aufsummierten Teilergebnisse, wie es speziell beim Dezimierungsfilter gewünscht ist.

Für die Realisierung des komplexwertigen Filters, wie er in Figur 8 dargestellt ist, kann man beispielsweise die beiden Teilfilter-Übertragungsfunktionen H1(Z) und H2(Z) in der gleichen Weise anwenden wie bei dem Polyphasenfilter mit zwei Teilfiltern, wie er in Figur 7 dargestellt ist.

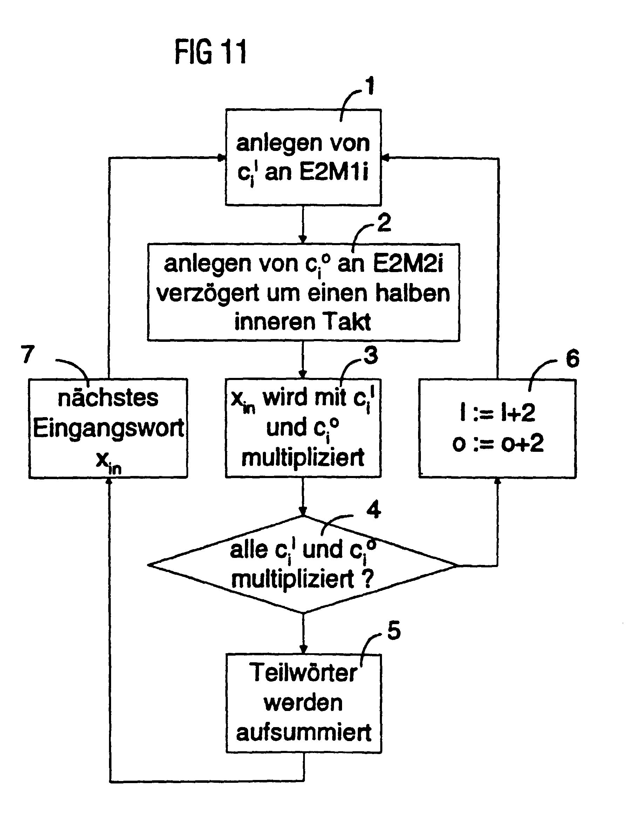

Die Verfahren zur Mehrfachnutzung des Filters F in Koeffizientenwortbreite weisen in jedem Koeffizientenblock KBi folgende Verfahrensschritte auf, die parallel in jedem Koeffizientenblock KBi durchgeführt werden (vgl. Figur 11).

Die einzelnen Koeffizientenbits $c_i^l$ und $c_i^o$ werden jeweils für eine Dauer eines inneren Taktes des Filters F an den zweiten Eingang E2M1i der ersten Multipliziererzelle M1i bzw. den zweiten Eingang E2M2i zweiten Multipliziererzelle M2i gelegt. Die angelegten Bits werden jeweils mit dem Eingangswort $x_{in}$ multipliziert 3.

Hierbei werden die Koeffizientenbits $c_i^l$ gerader Wertigkeit an den zweiten Eingang E2M1i der ersten Multiplizierzelle M1i gelegt 1. Die Koeffizientenbits $c_i^o$ ungerader Wertigkeit werden an den zweiten Eingang E2M2i zweiten Multipliziererzelle M2i gelegt, allerdings verzögert um einen halben inneren Takt 2, was durch die erste Verzögerungseinheit V1i erreicht wird.

Die Multiplikationen müssen für alle Koeffizientenbits durchgeführt werden 4, 6.

Die durch die Multiplikationen entstandenen Teilwörter werden in einem weiteren Schritt unter Beachtung ihrer jeweiligen Wertigkeit aufsummiert 5.

Die Summation kann auf verschiedene Arten erfolgen 15, entweder in jedem Koeffizientenblock KBi einzeln 16 (vgl. Figur 2) oder erst in der Gesamtaddierereinheit accu 17.

Nachdem ein Eingangswort komplett multipliziert wurde, wird ein neues Eingangswort bearbeitet 7.

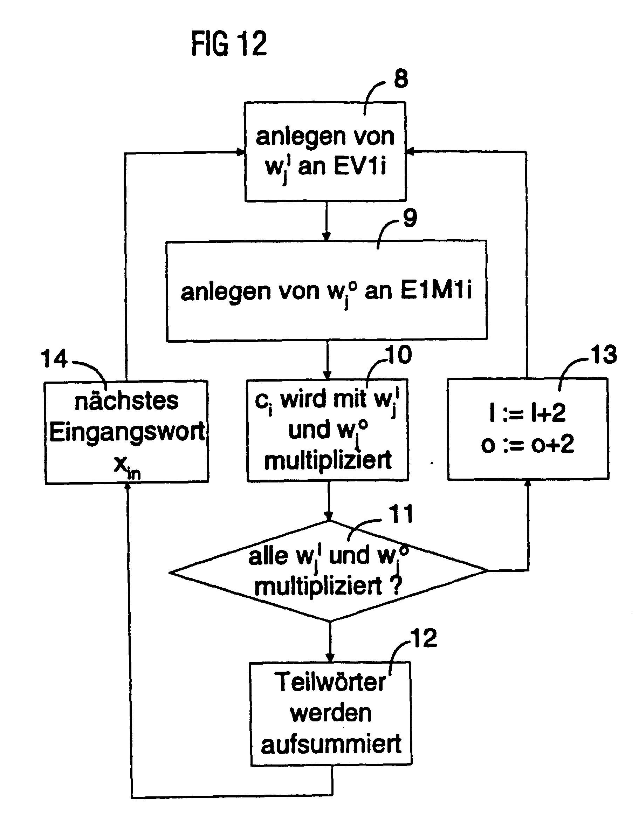

In Figur 12 ist ein Ablaufdiagramm dargestellt, das die einzelnen Verfahrensschritte des Verfahrens zur Mehrfachnutzung des Filters F in Richtung der Eingangswortbreite beschreibt.

Hierbei werden die einzelnen Bits $w_j^l$, $w_j^o$ des Eingangswortes $x_{in}$ jeweils mit einem "ganzen" Koeffizienten multipliziert 10.

Dafür werden die einzelnen Eingangswortbits $w_j^l$ gerader Wertigkeit an den Eingang EV1 der ersten Verzögerungseinheit V1i gelegt, wo sie um einen halben inneren Takt verzögert werden, und dann an dem ersten Eingang E1M2i der zweiten Multipliziererzelle M2i anliegen 8.

Die einzelnen Eingangswortbits $w_j^o$ ungerader Wertigkeit werden direkt jeweils an den ersten Eingang E1m1i der ersten Multipliziererreinheit M1i gelegt 9.

Dies geschieht für alle Eingangswortbits $w_j^l$ und $w^o$ des Eingangswortes $x_{in}$ 11, 13.

Die durch die Multiplikationen entstandenen Teilwörter werden aufsummiert 12.

Nachdem ein Eingangswort $x_{in}$ komplett gefiltert wurde, wird das Verfahren für ein weiteres Eingangswort wieder neu durchgeführt 14.

## Patentansprüche

1. Schaltungsanordnung eines digitalen Filters (F) mit

   - einem Schaltungseingang, dem ein Eingangswort zuführbar ist,
   - n Koeffizientenblöcken (KBi; i=1..n), wobei jeder Koeffizientenblock (KBi) folgende Komponenten aufweist:

      -- eine erste Multipliziererreinheit (M1i) und eine zweite Multipliziererreinheit (M2i),
      -- eine erste Addierereinheit (A1i) und eine zweite Addiereinheit (A2i), wobei ein erster Eingang (E1A1i) der ersten Addierereinheit (A1i) mit einem Ausgang (AM1i) der ersten Multipliziererreinheit (M1i) gekoppelt ist und wobei ein erster Eingang (E1A2i) der zweiten Addiereinheit (A2i) mit einem Ausgang (AM2i) der zweiten Multipliziererreinheit (M2i) gekoppelt ist,
      -- eine erste Verzögerungseinheit (V1i), deren Eingang (EV1i) mit einem ersten Eingang (E1M1i) der ersten Multipliziererreinheit (M1i) gekoppelt ist und deren Ausgang (AV1i) mit einem ersten Eingang (E1M2i) der zweiten Multipliziererreinheit (M2i) gekoppelt ist,
      -- eine zweite Verzögerungseinheit (V2i), deren Eingang (EV2i) mit einem Ausgang (AA1i) der ersten Addiereinheit (A1i) gekoppelt ist und deren Ausgang (AV2i) mit einem zweiten Eingang (E2A2i) der zweiten Addiereinheit (A2i) gekoppelt ist,
      -- eine dritte Verzögerungseinheit (V3i), deren Eingang (EV3i) mit einem Ausgang (AA2i) der zweiten Addiereinheit (A2i) gekoppelt ist und deren Ausgang (AV3i) mit einem zweiten Eingang (E2A1i+1) einer ersten Addiereinheit (A1i+1) eines folgenden Koeffizientenblocks (KBi+1) gekoppelt ist,
      -- einen zweiten Eingang (E2M1i) der ersten Multiplizierereinheit (M1i), an den jeweils ein Koeffizienten-Bit ($c_i^j$; i=1..n; 1 ∈ 0, 2, 4, 6, .., $w_k$-2) gerader Wertigkeit angelegt wird,

-- einen zweiten Eingang (E2M2i) der zweiten Multiplizierereinheit (M2i), an den jeweils ein Koeffizienten-Bit ($c_i^o$; i=1..n; o ∈ 1, 3, 5, 7, .., $w_k$-1) ungerader Wertigkeit angelegt wird,

-- eine Registereinheit (Ri), wobei ein Eingang (ERi) der Registereinheit (Ri) mit einem Ausgang (ARi+1) einer Registereinheit (Ri+1) eines folgenden Koeffizientenblocks (KBi+1) gekoppelt ist und wobei ein Ausgang (-ARi) der Registereinheit (Ri) mit dem ersten Eingang (E1m1i) der ersten Multiplizierereinheit (M1i) gekoppelt ist,

- einer Gesamtaddiereinheit (accu), deren Eingang mit dem Ausgang (AV3n) der dritten Verzögerungseinheit (V3n) des n-ten Koeffizientenblocks (KBn) gekoppelt ist, und

- einem mit der Gesamtaddiereinheit (accu) gekoppelten Schaltungsausgang, von dem ein Ausgangswort abgreifbar ist.

2. Schaltungsanordnung nach Anspruch 1, bei der die Registereinheit (Ri) ein Register aufweist, das immer nach einer Anzahl innerer Takte neu geladen wird, die der Hälfte einer Koeffizientenwortbreite ($w_k$) entspricht.

3. Schaltungsanordnung nach Anspruch 1, bei der die Registereinheit (Ri) ein Register weniger aufweist als die Hälfte einer Koeffizientenwortbreite ($w_k$), wobei jedes der Register nach jedem inneren Takt neu geladen wird.

4. Schaltungsanordnung eines digitalen Filters (F) mit

- einem Schaltungseingang, dem ein Eingangswort zuführbar ist,

- n Koeffizientenblöcken (KBi; i=1..n), wobei jeder Koeffizientenblock (KBi) folgende Komponenten aufweist:

-- eine erste Multiplizierereinheit (M1i) und eine zweite Multiplizierereinheit (M2i),

-- eine erste Addierereinheit (A1i) und eine zweite Addiereinheit (A2i), wobei ein erster Eingang (E1A1i) der ersten Addierereinheit (A1i) mit einem Ausgang (AM1i) der ersten Multiplizierereinheit (M1i) gekoppelt ist und wobei ein erster Eingang (E1A2i) der zweiten Addiereinheit (A2i) mit einem Ausgang (AM2i) der zweiten Multiplizierereinheit (M2i) gekoppelt ist,

-- eine zweite Verzögerungseinheit (V2i), deren Eingang (EV2i) mit einem Ausgang (AA1i) der ersten Addiereinheit (A1i) gekoppelt ist und deren Ausgang (AV2i) mit einem zweiten Eingang (E2A2i) der zweiten Addiereinheit (A2i) gekoppelt ist,

-- eine dritte Verzögerungseinheit (V3i), deren Eingang (EV3i) mit einem Ausgang (AA2i) der zweiten Addiereinheit (A2i) gekoppelt ist,

-- einen zweiten Eingang (E2M1i) der ersten Multiplizierereinheit (M1i), an den jeweils für die Dauer eines inneren Takts ein Koeffizienten-Bit ($c_i^j$; i=1..n; 1 ∈ 0, 2, 4, 6, .., $w_k$-2) gerader Wertigkeit angelegt wird,

-- einen zweiten Eingang (E2M2i) der zweiten Multiplizierereinheit (M2i), an den jeweils für die Dauer eines inneren Takts ein Koeffizienten-Bit ($c_i^o$; i=1..n; o ∈ 1, 3, 5, 7, .., $w_k$-1) ungerader Wertigkeit angelegt wird, und

-- eine Registereinheit (Ri), wobei ein Eingang (ERi) der Registereinheit (Ri) mit einem Ausgang (AV3i) der dritten Verzögerungseinheit (AV3i) gekoppelt ist und wobei ein Ausgang der Registereinheit (Ri) mit einem zweiten Eingang (E2A1i+1) einer ersten Addiereinheit (A1i+1) eines folgenden Koeffizientenblocks (KBi+1) gekoppelt ist,

- einer ersten Verzögerungseinheit (V1), deren Eingang (EV1) mit einem ersten Eingang (E1m11) der ersten Multiplizierereinheit (M11) eines ersten Koeffizientenblocks (KB1) gekoppelt ist und deren Ausgang (AV1) mit allen ersten Eingängen (E1M2i) aller zweiten Multiplizierereinheiten (M2i) gekoppelt ist,

- einer Gesamtaddiereinheit (accu), deren Eingang mit dem Ausgang (AV3n) der dritten Verzögerungseinheit (V3n) des n-ten Koeffizientenblocks (KBn) gekoppelt ist, und

- einem mit der Gesamtaddiereinheit (accu) gekoppelten Schaltungsausgang, von dem ein Ausgangswort abgreifbar ist.

5. Schaltungsanordnung eines digitalen Filters (F) mit

- einem Schaltungseingang, dem ein Eingangswort zuführbar ist,

- n Koeffizientenblöcken (KBi; i=1..n), wobei jeder Koeffizientenblock (KBi) folgende Komponenten aufweist:

-- eine erste Multiplizierereinheit (M1i) und eine zweite Multiplizierereinheit (M2i),

-- eine erste Addierereinheit (A1i) und eine zweite Addiereinheit (A2i), wobei ein erster Eingang (E1A1i) der ersten Addierereinheit (A1i) mit einem Ausgang (AM1i) der ersten Multiplizierereinheit (M1i) gekoppelt ist und wobei ein erster Eingang (E1A2i) der zweiten Addierereinheit (A2i) mit einem Ausgang (AM2i) der zweiten Multiplizierereinheit (M2i) gekoppelt ist,

-- eine zweite Verzögerungseinheit (V2i), deren Eingang (EV2i) mit einem Ausgang (AA1i) der ersten Addiereinheit (A1i) gekoppelt ist und deren Ausgang (AV2i) mit einem zweiten Eingang (E2A2i) der zweiten Addiereinheit (A2i) gekoppelt ist,

-- eine dritte Verzögerungseinheit (V3i), deren Eingang (EV3i) mit einem Ausgang (AA2i) der zweiten Addiereinheit (A2i) gekoppelt ist,

-- einen zweiten Eingang (E2M1i) der ersten Multiplizierereinheit (M1i), an den jeweils für die Dauer eines inneren Takts ein Koeffizienten-Bit ($c_i^l$; i=1..n; $1 \in 0, 2, 4, 6, .., w_k-2$) gerader Wertigkeit angelegt wird,

-- einen zweiten Eingang (E2M2i) der zweiten Multiplizierereinheit (M2i), an den jeweils für die Dauer eines inneren Takts ein Koeffizienten-Bit ($c_i^o$; i=1..n; $o \in 1, 3, 5, 7, .., w_k-1$) ungerader Wertigkeit angelegt wird, und

-- eine Schaltereinheit (S), die zwei Schalterpositionen aufweist, wobei bei einer ersten Schalterposition (S1) der jeweilige zweite Eingang (E2A1i) der ersten Addiereinheit (A1i) eines Koeffizientenblocks (KBi) mit dem Augang (AV3i) der dritten Verzögerungseinheit (V3i) eines vorangegangenen Koeffizientenblocks (KBi-1) gekoppelt wird und wobei bei einer zweiten Schalterposition (S2) der jeweilige zweite Eingang (E2A1i) der ersten Addiereinheit (A1i) eines Koeffizientenblocks (KBi) mit dem Augang (AV3i) der dritten Verzögerungseinheit (V3i) desselben Koeffizientenblocks (KBi) gekoppelt wird,

- einer ersten Verzbgerungseinheit (V1), deren Eingang (EV1) mit einem ersten Eingang (E1m11) der ersten Multiplizierereinheit (M11) eines ersten Koeffizientenblocks (KB1) gekoppelt ist und deren Ausgang (AV1) mit allen ersten Eingängen (E1M2i) aller zweiten Multiplizierereinheiten (M2i) gekoppelt ist, und

- einem mit der Gesamtaddiereinheit (accu) gekoppelten Schaltungsausgang, von dem ein Ausgangswort abgreifbar ist.

6. Schaltungsanordnung eines digitalen Filters (F) mit

- einem Schaltungseingang, dem ein Eingangswort zuführbar ist,

- n Koeffizientenblöcken (KBi; i=1..n), wobei jeder Koeffizientenblock (KBi) folgende Komponenten aufweist:

-- eine erste Multiplizierereinheit (M1i) und eine zweite Multiplizierereinheit (M2i),

-- eine erste Addierereinheit (A1i) und eine zweite Addiereinheit (A2i), wobei ein erster Eingang (E1A1i) der ersten Addierereinheit (A1i) mit einem Ausgang (AM1i) der ersten Multiplizierereinheit (M1i) gekoppelt ist und wobei ein erster Eingang (E1A2i) der zweiten Addiereinheit (A2i) mit einem Ausgang (AM2i) der zweiten Multiplizierereinheit (M2i) gekoppelt ist,

-- eine erste Verzögerungseinheit (V1i), deren Eingang (EV1i) mit einem Ausgang (AR1i) einer ersten Registereinheit (R1i) gekoppelt ist und deren Ausgang (AV1i) mit einem ersten Eingang (E1M2i) der zweiten Multiplizierereinheit (M2i) gekoppelt ist,

-- eine zweite Verzögerungseinheit (V2i), deren Eingang (EV2i) mit einem Ausgang (AA1i) der ersten Addiereinheit (A1i) gekoppelt ist und deren Ausgang (AV2i) mit einem zweiten Eingang (E2A2i) der zweiten Addiereinheit (A2i) gekoppelt ist,

-- eine dritte Verzögerungseinheit (V3i), deren Eingang (EV3i) mit einem Ausgang (AA2i) der zweiten Addiereinheit (A2i) gekoppelt ist und deren Ausgang (AV3i) mit einem zweiten Eingang (E2A1i+1) einer ersten Addiereinheit (A1i+1) eines folgenden Koeffizientenblocks (KBi+1) gekoppelt ist,

-- einen zweiten Eingang (E2M1i) der ersten Multiplizierereinheit (M1i) und einen zweiten Eingang (E2M2i) der zweiten Multiplizierereinheit (M2i), an den jeweils ein Koeffizientenwort ($c_i$; i=1..n) angelegt wird,

-- die erste Registereinheit (R1i), die mit einem Eingang (ER1i) mit einem Ausgang (AR1i+1) einer ersten Registereinheit (R1i+1) eines folgenden Koeffizientenblocks (KBi+1) gekoppelt ist,

-- eine zweite Registereinheit (R2i), die mit einem Eingang (ER2i) mit einem Ausgang (AR2i+1) einer zweiten Registereinheit (R2i+1) eines folgenden Koeffizientenblocks (KBi+1) gekoppelt ist und die über einen Ausgang (AR2i) mit einem ersten Eingang (E1M1i) der ersten Multipliziereinheit (M1i) gekoppelt ist,

- einer Gesamtaddiereinheit (accu), deren Eingang mit dem Ausgang (AV3n) der dritten Verzögerungseinheit (V3n) des n-ten Koeffizientenblocks (KBn) gekoppelt ist, und

-   einem mit der Gesamtaddiereinheit (accu) gekoppelten Schaltungsausgang, von dem ein Ausgangswort abgreifbar ist.

7.  Schaltungsanordnung nach Anspruch 6, bei dem die erste Registereinheit (R1i) und die zweite Registereinheit (R2i) eine Wortbreite von eins und eine Länge von $\frac{w_m}{2}$ - 1 aufweist.

8.  Schaltungsanordnung nach Anspruch 6, bei dem die erste Registereinheit (R1i) und die zweite Registereinheit (R2i) eine Wortbreite von eins und eine Länge von $w_m$-1 aufweist.

9.  Schaltungsanordnung eines Interpolationsfilters (IF) mit einem Filter (F) nach einem der Ansprüche 1 bis 7.

10. Schaltungsanordnung eines Dezimierungsfilters (DF) mit einem Filter (F) nach einem der Ansprüche 1 bis 7.

11. Schaltungsanordnung eines komplexwertigen Filters (KF) mit einem Filter (F) nach einem der Ansprüche 1 bis 7.

12. Verwendung eines Filters (F) nach einem der Ansprüche 1 bis 8, zu dessen Mehrfachnutzung dessen innerer Takt um ein ganzzahliges Vielfaches schneller ist als ein äußerer Takt, nach dem, Eingangswörter ($x_{in}$) an einem Ausgang (A) des Filters (F) anliegen müssen,

    -   bei dem in jedem, für jeweils einen Koeffizienten ($c_i$) vorgesehenen Koeffizientenblock (KBi) folgende Schritte vorgesehen sind:

        --  es werden jeweils zeitlich nacheinander für die Dauer eines inneren Taktes ein Koeffizientbit gerader Wertigkeit ($c_i^l$; i=1. .n; $l \in 0, 2, 4, 6, .., w_k$-2) an einen zweiten Eingang (E2M1i) einer ersten Multipliziererzelle (M1i) angelegt,

        --  es werden jeweils zeitlich nacheinander für die Dauer eines inneren Taktes, verzögert um einen halben inneren Takt gegenüber dem Anlegen des Koeffizientenbits gerader Wertigkeit ($c_i^l$ i=1..n; $l \in 0, 2, 4, 6, .., w_k$-2) ein Koeffizientenbit ungerader Wertigkeit ($c_i^o$; i=1..n; $o \in 1, 3, 5, 7, .., w_k$-1) an einen zweiten Eingang (E2M2i) einer zweiten Multipliziererzelle (M2i) angelegt,

        --  es wird jeweils das angelegte Eingangswort ($x_{in}$) mit den angelegten Koeffizientenbits in der ersten Multipliziererzelle (M1i) und der zweiten Mltipliziererzelle (M2i) multipliziert, und

    -   bei dem durch die Multiplikationen entstandene Teilwörter entsprechend ihrer Wertigkeit zu einem Gesamtwort summiert werden.

13. Verwendung nach Anspruch 12, bei dem die Summation der Teilwörter für jeden Koeffizienten ($c_i$) in jedem Koeffizientenblock (KBi) einzeln durchgeführt wird.

14. Verwendung nach Anspruch 12, bei dem die Summation aller Teilwörter aller Koeffizienten ($c_i$) in einer Gesamtaddiereinheit (accu) durchgeführt wird.

15. Verwendung nach einem der Ansprüche 9 bis 14, bei dem Koeffizienten mehrerer Filterfunktionen (Hr (z); r=1..s) nacheinander abwechselnd an die Multipliziererreinheiten (M1i; M2i) angelegt werden.

16. Verwendung eines Filters (F) nach einem der Ansprüche 1 bis 8, zu dessen Mehrfachnutzung dessen innerer Takt um ein ganzahliges Vielfaches schneller ist als ein äußerer Takt, nach dem Eingangswörter ($x_{in}$) einer Eingangsdatenwortbreite ($w_j$; j=1..m) an einem Ausgang (A) des Filters (F) anliegen müssen,

    -   bei dem in jedem, für jeweils einen Koeffizienten ($c_i$) vorgesehenen Koeffizientenblock (KBi) folgende Schritte vorgesehen sind:

        --  es werden jeweils zeitlich nacheinander für die Dauer eines inneren Taktes ein Eingangswortbit gerader Wertigkeit ($w_j^l$; $l \in 0, 2, 4, 6, .., w_m$-2) an einen Eingang (EV1i) einer ersten Verzögerungseinheit (V1i) angelegt,

        --  es werden jeweils zeitlich nacheinander für die Dauer eines inneren Taktes, ein Eingangswortbit ungerader Wertigkeit ($w_j^o$; $o \in 1, 3, 5, 7, .., w_m$-1) an einen ersten Eingang (E1m1i) einer ersten Multipliziererzelle (M1i) angelegt,

        --  es werden jeweils das an einen ersten Eingang (E1M1i) einer ersten Multipliziererzelle (M1i) und das an einen ersten Eingang (E1M2i) einer zweiten Multipliziererzelle (M2i) angelegte Koeffizientenwort ($c_i$) multipliziert, und

    -   bei dem durch die Multiplikationen entstandene Teilwörter entsprechend ihrer Wertigkeit in einer Gesamtaddiereinheit (accu) zu einem Gesamtwort summiert werden.

**Claims**

1.  A circuit arrangement of a digital filter (F) with

- a circuit input, to which an input word can be fed,
- n coefficient blocks (KBi; i=1..n), each coefficient block (KBi) having the following components:

  -- a first multiplier unit (M1i) and a second multiplier unit (M2i),
  -- a first adder unit (A1i) and a second adder unit (A2i), a first input (E1A1i) of the first adder unit (A1i) being connected to an output (AM1i) of the first multiplier unit (M1i), and a first input (E1A2i) of the second adder unit (A2i) being connected to an output (AM2i) of the second multiplier unit (M2i),
  -- a first delay unit (V1i), whose input (EV1i) is connected to a first input (E1M1i) of the first multiplier unit (M1i) and whose output (AV1i) is connected to a first input (E1M2i) of the second multiplier unit (M2i),
  -- a second delay unit (V2i), whose input (EV2i) is connected to an output (AA1i) of the first adder unit (A1i) and whose output (AV2i) is connected to a second input (E2A2i) of the second adder unit (A2i),
  -- a third delay unit (V3i), whose input (EV3i) is connected to an output (AA2i) of the second adder unit (A2i) and whose output (AV3i) is connected to a second input (E2A1i+1) of a first adder unit (A1i+1) of a following coefficient block (KBi+1),
  -- a second input (E2M1i) of the first multiplier unit (M1i), to which in each case a coefficient bit ($c_l^j$; i=1..n; $1 \in 0, 2, 4, 6, .., w_k-2$) with even-numbered significance is applied,
  -- a second input (E2M2i) of the second multiplier unit (M2i), to which in each case a coefficient bit ($c_l^0$; i=1..n; $0 \in 1, 3, 5, 7, .., w_k-1$) with odd-numbered significance is applied,
  -- a register unit (Ri), an input (ERi) of the register unit (Ri) being connected to an output (ARi+1) of a register unit (Ri+1) of a following coefficient block (KBi+1), and an output (ARi) of the register unit (Ri) being connected to the first input (E1M1i) of the first multiplier unit (M1i), and

- an accumulator register (accu) whose input is connected to the output (AV3n) of the third delay unit (V3n) of the n-th coefficient block (KBn), and
- a circuit output, which is coupled to the accumulator register (accu) and from which an output word can be tapped.

2. The circuit arrangement as claimed in claim 1, in which the register unit (Ri) has a register which is always reloaded after a number of internal clock pulses which corresponds to half a coefficient word length ($w_k$).

3. The circuit arrangement as claimed in claim 1, in which the register unit (Ri) has one register fewer than half a coefficient word length ($w_k$), each of the registers being reloaded after each internal clock pulse.

4. The circuit arrangement of a digital filter (F) with

- a circuit input, to which an input word can be fed,
- n coefficient blocks (KBi; i=1..n), each coefficient block (KBi) having the following components:

  -- a first multiplier unit (M1i) and a second multiplier unit (M2i),
  -- a first adder unit (A1i) and a second adder unit (A2i), a first input (E1A1i) of the first adder unit (A1i) being connected to an output (AM1i) of the first multiplier unit (M1i), and a first input (E1A2i) of the second adder unit (A2i) being connected to an output (AM2i) of the second multiplier unit (M2i),
  -- a second delay unit (V2i), whose input (EV2i) is connected to an output (AA1i) of the first adder unit (A1i) and whose output (AV2i) is connected to a second input (E2A2i) of the second adder unit (A2i),
  -- a third delay unit (V3i), whose input (EV3i) is connected to an output (AA2i) of the second adder unit (A2i),
  -- a second input (E2M1i) of the first multiplier unit (M1i), to which a coefficient bit ($c_l^j$; i=1.. n; $1 \in 0, 2, 4, 6, .., w_k-2$) with even-numbered significance is applied in each case for the duration of one internal clock pulse,
  -- a second input (E2M2i) of the second multiplier unit (M2i), to which a coefficient bit ($c_l^0$; i=1..n; $0 \in 1, 3, 5, 7, .., w_k-1$) with odd-numbered significance is applied in each case for the duration of one internal clock pulse, and -- a register unit (Ri), an input (ERi) of the register unit (Ri) being connected to an output (AV3i) of the third delay unit (AV3i), and an output of the register unit (Ri) being connected to a second input (E2A1i+1) of a first adder unit (A1i+1) of a following coefficient block (KBi+1),

- a first delay unit (V1) whose input (EV1) is connected to a first input (E1M11) of the first multiplier unit (M11) of a first coefficient block (KBi) and whose output (AV1) is connected to all the first inputs (E1M2i) of all the second multiplier units (M2i), and

- an accumulator register (accu) whose input is connected to the output (AV3n) of the third delay unit (V3n) of the n-th coefficient block (KBn), and

- a circuit output, which is coupled to the accumulator register (accu) and from which an output word can be tapped.

5. The circuit arrangement of a digital filter (F) with

- a circuit input, to which an input word can be fed,

- n coefficient blocks (KBi; i=1..n), each coefficient block (KBi) having the following components:

  -- a first multiplier unit (M1i) and a second multiplier unit (M2i),

  -- a first adder unit (A1i) and a second adder unit (A2i), a first input (E1A1i) of the first adder unit (A1i) being connected to an output (AM1i) of the first multiplier unit (M1i), and a first input (E1A2i) of the second adder unit (A2i) being connected to an output (AM2i) of the second multiplier unit (M2i),

  -- a second delay unit (V2i), whose input (EV2i) is connected to an output (AA1i) of the first adder unit (A1i) and whose output (AV2i) is connected to a second input (E2A2i) of the second adder unit (A2i),

  -- a third delay unit (V3i), whose input (EV3i) is connected to an output (AA2i) of the second adder unit (A2i),

  -- a second input (E2M1i) of the first multiplier unit (M1i), to which a coefficient bit ($c_j^l$; i=1.. n; $1 \in 0, 2, 4, 6, .., w_k-2$) with even-numbered significance is applied in each case for the duration of one internal clock pulse,

  -- a second input (E2M2i) of the second multiplier unit (M2i), to which a coefficient bit ($c_j^0$; i=1..n; $0 \in 1, 3, 5, 7, .., w_k-1$) with odd-numbered significance is applied in each case for the duration of one internal clock pulse, and

  -- a switch unit (S), which has two switch positions, the respective second input (E2A1i) of the first adder unit (A1i) of a coefficient block (KBi) being connected to the output (AV3i) of the third delay unit (V3i) of a preceding coefficient block (KBi-1) in a first switch position (S1), and the respective second input (E2A1i) of the first adder unit (A1i) of a coefficient block (KBi) being connected to the output (AV3i) of the third delay unit (V3i) of the same coefficient block (KBi) in a second switch position (S2),

- a first delay unit (V1) whose input (EV1) is connected to a first input (E1M11) of the first multiplier unit (M11) of a first coefficient block (KB1) and whose output (AV1) is connected to all the first inputs (E1M2i) of all the second multiplier units (M2i), and

- a circuit output, which is coupled to the accumulator register (accu) and from which an output word can be tapped.

6. The circuit arrangement of a digital filter (F) with

- a circuit input, to which an input word can be fed,

- n coefficient blocks (KBi; i=1..n), each coefficient block (KBi) having the following components:

  -- a first multiplier unit (M1i) and a second multiplier unit (M2i),

  -- a first adder unit (A1i) and a second adder unit (A2i), a first input (E1A1i) of the first adder unit (A1i) being connected to an output (AM1i) of the first multiplier unit (M1i), and a first input (E1A2i) of the second adder unit (A2i) being connected to an output (AM2i) of the second multiplier unit (M2i),

  -- a first delay unit (V1i), whose input (EV1i) is connected to an output (AR1i) of a first register unit (R1i) and whose output (AV1i) is connected to a first input (E1M2i) of the second multiplier unit (M2i),

  -- a second delay unit (V2i), whose input (EV2i) is connected to an output (AA1i) of the first adder unit (A1i) and whose output (AV2i) is connected to a second input (E2A2i) of the second adder unit (A2i),

  -- a third delay unit (V3i), whose input (EV3i) is connected to an output (AA2i) of the second adder unit (A2i) and whose output (AV3i) is connected to a second input (E2A1i+1) of a first adder unit (A1i+1) of a following coefficient block (KBi+1),

  -- a second input (E2M1i) of the first multiplier unit (M1i) and a second input (E2M2i) of the second multiplier unit (M2i), to which in each case a coefficient word ($C_i$; i=1..n) is applied,

  -- the first register unit (R1i), which is connected by an input (ER1i) to an output (AR1i+1) of a first register unit (R1i+1) of a following coefficient block (KBi+1),

-- a second register unit (R2i), which is connected by an input (ER2i) to an output (AR2i+1) of a second register unit (R2i+1) of a following coefficient block (KBi+1), and which is connected by means of an output (AR2i) to a first input (E1M1i) of the first multiplier unit (M1i),

- an accumulator register (accu) whose input is connected to the output (AV3n) of the third delay unit (V3n) of the n-th coefficient block (KBn), and

- a circuit output, which is coupled to the accumulator register (accu) and from which an output word can be tapped.

7. The circuit arrangement as claimed in claim 6, in which the first register unit (R1i) and the second register unit (R2i) have a word length of one and a length of $\frac{w_m}{2}$ - 1.

8. The circuit arrangement as claimed in claim 6, in which the first register unit (R1i) and the second register unit (R2i) have a word length of one and a length of $w_m$-1.

9. A circuit arrangement of an interpolation filter (IF) with a filter (F) as claimed in one of claims 1 to 7.

10. A circuit arrangement of a decimating filter (DF) with a filter (F) as claimed in one of claims 1 to 7.

11. A circuit arrangement of a complex valued filter (KF) with a filter (F) as claimed in one of claims 1 to 7.

12. A method for the multiple use of a filter (F) as claimed in one of claims 1 to 8, whose internal clock is an integral order of magnitude faster than an external clock, in accordance with which input words ($x_{in}$) must be present at an output (A) of the filter (F),

    - in which method the following steps are provided in each coefficient block (KBi) provided for one coefficient ($c_i$) in each case:

        -- a coefficient bit with even-numbered significance ($c_l^j$; i=1..n; $1 \in 0, 2, 4, 6, .., w_k$-2) is applied, in each case in a chronological succession for the duration of one internal clock pulse, to a second input (E2M1i) of a first multiplier cell (M1i),
        -- a coefficient bit with odd-numbered significance ($c_l^0$; i=1..n; $0 \in 1, 3, 5, 7, .., w_k$-1) is applied, in each case in a chronological succession for the duration of one internal clock pulse and delayed by half an internal clock pulse with respect to the application of the coefficient bit with even-numbered

significance ($c_l^j$; i=1..n; $1 \in 0, 2, 4, 6, .., w_k$-2), to a second input (E2M2i) of a second multiplier cell (M2i),
        -- in each case the applied input word ($x_{in}$) is multiplied by the applied coefficient bits in the first multiplier cell (M1i) and in the second multiplier cell (M2i), and

    - in which method partwords which have been produced as a result of the multiplications are summed in accordance with the significance to form a composite word.

13. The method as claimed in claim 12, in which the summation of the partwords is carried out individually for each coefficient ($c_i$) in each coefficient block (KBi).

14. The method as claimed in claim 12, in which the summation of all the partwords of all the coefficients ($c_i$) is carried out in an accumulator register (accu).

15. The method as claimed in one of claims 9 to 14, in which coefficients of a plurality of filter functions (Hr(z) ; r=1..s) are applied to the multiplier units (M1i; M2i) in alternating succession.

16. A method for the multiple use of a filter (F) as claimed in one of claims 1 to 8, whose internal clock is faster by an integral order of magnitude than an external clock, according to which input words ($x_{in}$) of an input data word length ($w_j$; j=1..m) must be present at an output (A) of the filter (F),

    - in which method the following steps are provided in each coefficient block (KBi) which is provided for one coefficient ($c_i$) in each case:

        -- an input word bit with even-numbered significance ($w_j^l$; $1 \in 0, 2, 4, 6, .., w_m$-2) is applied, in each case in a chronological succession for the duration of one internal clock pulse, to an input (EV1i) of a first delay unit (V1i),
        -- an input word bit with odd-numbered significance ($w_j^l$; $0 \in 1, 3, 5, 7, .., w_m$-1) is applied, in each case in a chronological succession for the duration of one internal clock pulse, to a first input (E1M1i) of a first multiplier cell (M1i),
        -- the coefficient word ($c_i$) which is applied to a first input (E1M1i) of a first multiplier cell (M1i) and the coefficient word ($c_i$) which is applied to a first input (E1M2i) of a second multiplier cell (M2i) are multiplied in each case, and

    - in which method partwords which have been produced as a result of the multiplications are summed in accordance with the significance in an accumulator register (accu) to form a composite word.

## Revendications

1. Circuit d'un filtre numérique (F) comportant

   - une entrée de circuit à laquelle un mot d'entrée peut être envoyé,
   - n blocs de coefficients (KBi ; i = 1 .. n), chaque bloc de coefficient (KBi) comportant les éléments suivants :

     -- une première unité de multiplication (M1i) et une deuxième unité de multiplication (M2i),
     -- une première unité d'addition (A1i) et une deuxième unité d'addition (A2i), une première entrée (E1A1i) de la première unité d'addition (A1i) étant reliée à une sortie (AM1i) de la première unité de multiplication (M1i) et une première entrée (E1A2i) de la deuxième unité d'addition (A2i) étant reliée à une sortie (AM2i) de la deuxième unité de multiplication (M2i),
     -- une première unité de retardement (V1i) dont l'entrée (EV1i) est reliée à une première entrée (E1M1i) de la première unité de multiplication (M1i) et dont la sortie (AV1i) est reliée à une première entrée (E1M2i) de la deuxième unité de multiplication (M2i),
     -- une deuxième unité de retardement (V2i) dont l'entrée (EV2i) est reliée à une sortie (AA1i) de la première unité d'addition (A1i) et dont la sortie (AV2i) est reliée à une deuxième entrée (E2A2i) de la deuxième unité d'addition (A2i),
     -- une troisième unité de retardement (V3i) dont l'entrée (EV3i) est reliée à une sortie (AA2i) de la deuxième unité d'addition (A2i) et dont la sortie (AV3i) est reliée à une deuxième entrée (E2A1i + 1) d'une première unité d'addition (A1i + 1) d'un bloc de coefficient suivant (KBi + 1),
     -- une deuxième entrée (E2M1i) de la première unité de multiplication (M1i), à laquelle est appliqué à chaque fois un bit de coefficient ($c_j^l$; i = 1 .. n ; 1 $\in$ 0, 2, 4, 6, .., $w_k$ - 2) de poids pair,
     -- une deuxième entrée (E2M2i) de la deuxième unité de multiplication (M2i), à laquelle est appliqué à chaque fois un bit de coefficient ($c_j^l$; i = 1 .. n ; o $\in$ 1, 3, 5, 7, .., $w_k$ - 1) de poids impair,

     -- une unité de registre (Ri), une entrée (ERi) de l'unité de registre (Ri) étant reliée à une sortie (ARi + 1) d'une unité de registre (Ri + 1) d'un bloc de coefficient suivant (KBi + 1) et une sortie (ARi) de l'unité de registre (Ri) étant reliée à la première entrée (E1M1i) de la première unité de multiplication (M1i),

   - une unité de totalisation (accu) dont l'entrée est reliée à la sortie (AV3n) de la troisième unité de retardement (V3n) du n-ième bloc de coefficient (KBn), et
   - une sortie de circuit qui est reliée à l'unité de totalisation (accu) et de laquelle un mot de sortie peut être prélevé.

2. Circuit selon la revendication 1, dans lequel l'unité de registre (Ri) comporte un registre qui est toujours de nouveau chargé après un nombre de cycles internes qui correspond à la moitié d'une largeur de mot de coefficient ($w_k$).

3. Circuit selon la revendication 1, dans lequel l'unité de registre (Ri) comporte un registre de moins que la moitié d'une largeur de mot de coefficient ($w_k$), chacun des registres étant de nouveau chargé après chaque cycle interne.

4. Circuit d'un filtre numérique (F) comportant

   - une entrée de circuit à laquelle un mot d'entrée peut être envoyé,
   - n blocs de coefficients (KBi; i = 1 .. n), chaque bloc de coefficient (KBi) comportant les éléments suivants :

     -- une première unité de multiplication (M1i) et une deuxième unité de multiplication (M2i),
     -- une première unité d'addition (A1i) et une deuxième unité d'addition (A2i), une première entrée (E1A1i) de la première unité d'addition (A1i) étant reliée à une sortie (AM1i) de la première unité de multiplication (M1i) et une première entrée (E1A2i) de la deuxième unité d'addition (A2i) étant reliée à une sortie (AM2i) de la deuxième unité de multiplication (M2i),
     -- une deuxième unité de retardement (V2i) dont l'entrée (EV2i) est reliée à une sortie (AA1i) de la première unité d'addition (A1i) et dont la sortie (AV2i) est reliée à une deuxième entrée (E2A2i) de la deuxième unité d'addition (A2i),
     -- une troisième unité de retardement (V3i) dont l'entrée (EV3i) est reliée à une sortie (AA2i) de la deuxième unité d'addition (A2i),

-- une deuxième entrée (E2M1i) de la première unité de multiplication (M1i), à laquelle est appliqué à chaque fois pour la durée d'un cycle interne un bit de coefficient ($c_i^l$; i = 1 .. n ; 1 ∈ 0, 2, 4, 6, .., $w_k$ - 2) de poids pair,

-- une deuxième entrée (E2M2i) de la deuxième unité de multiplication (M2i), à laquelle est appliqué à chaque fois pour la durée d'un cycle interne un bit de coefficient ($c_i^o$ ; i = 1 .. n ; o ∈ 1, 3, 5, 7, ..., $w_k$ - 1) de poids impair, et

-- une unité de registre (Ri), une entrée (ERi) de l'unité de registre (Ri) étant reliée à une sortie (AV3i) de la troisième unité de retardement (V3i) et une sortie de l'unité de registre (Ri) étant reliée à une deuxième entrée (E2A1i + 1) d'une première unité d'addition (A1i + 1) d'un bloc de coefficient suivant (KBi + 1),

- une première unité de retardement (V1) dont l'entrée (EV1) est reliée à une première entrée (E1m11) de la première unité de multiplication (M11) d'un premier bloc de coefficient (KB1) et dont la sortie (AV1) est reliée à toutes les premières entrées (E1M2i) de toutes les deuxièmes unités de multiplication (M2i),

- une unité de totalisation (accu) dont l'entrée est reliée à la sortie (AV3n) de la troisième unité de retardement (V3n) du n-ième bloc de coefficient (KBn), et

- une sortie de circuit qui est reliée à l'unité de totalisation (accu) et de laquelle un mot de sortie peut être prélevé.

5. Circuit d'un filtre numérique (F) comportant

- une entrée de circuit à laquelle un mot d'entrée peut être envoyé,

- n blocs de coefficients (KBi; i = 1 .. n), chaque bloc de coefficient (KBi) comportant les éléments suivants :

-- une première unité de multiplication (M1i) et une deuxième unité de multiplication (M2i),

-- une première unité d'addition (A1i) et une deuxième unité d'addition (A2i), une première entrée (E1A1i) de la première unité d'addition (A1i) étant reliée à une sortie (AM1i) de la première unité de multiplication (M1i) et une première entrée (E1A2i) de la deuxième unité d'addition (A2i) étant reliée à une sortie (AM2i) de la deuxième unité de multiplication (M2i),

-- une deuxième unité de retardement (V2i) dont l'entrée (EV2i) est reliée à une sortie (AA1i) de la première unité d'addition (A1i) et dont la sortie (AV2i) est reliée à une deuxième entrée (E2A2i) de la deuxième unité d'addition (A2i),

-- une troisième unité de retardement (V3i) dont l'entrée (EV3i) est reliée à une sortie (AA2i) de la deuxième unité d'addition (A2i),

-- une deuxième entrée (E2M1i) de la première unité de multiplication (M1i), à laquelle est appliqué à chaque fois pour la durée d'un cycle interne un bit de coefficient ($c_i^l$ ; i = 1 .. n ; 1 ∈ 0, 2, 4, 6, .., $w_k$ - 2) de poids pair,

-- une deuxième entrée (E2M2i) de la deuxième unité de multiplication (M2i), à laquelle est appliqué à chaque fois pour la durée d'un cycle interne un bit de coefficient ($c_i^o$ ; i = 1 .. n ; o ∈ 1, 3, 5, 7, ..., $w_k$ - 1) de poids impair, et

-- une unité de commutation (S) qui comporte deux positions de commutation telles que, dans une première position de commutation (S1), la deuxième entrée respective (E2A1i) de la première unité d'addition (A1i) d'un bloc de coefficient (KBi) est reliée à la sortie (AV3i - 1) de la troisième unité de retardement (V3i - 1) d'un bloc de coefficient précédent (KBi - 1) et, dans une deuxième position de commutation (S2), la deuxième entrée respective (E2A1i) de la première unité d'addition (A1i) d'un bloc de coefficient (KBi) est reliée à la sortie (AV3i) de la troisième unité de retardement (V3i) du même bloc de coefficient (KBi),

- une première unité de retardement (V1) dont l'entrée (EV1) est reliée à une première entrée (E1m11) de la première unité de multiplication (M11) d'un premier bloc de coefficient (KB1) et dont la sortie (AV1) est reliée à toutes les premières entrées (E1M2i) de toutes les deuxièmes unités de multiplication (M2i), et

- une sortie de circuit de laquelle un mot de sortie peut être prélevé.

6. Circuit d'un filtre numérique (F) comportant

- une entrée de circuit à laquelle un mot d'entrée peut être envoyé,

- n blocs de coefficients (KBi ; i = 1 .. n), chaque bloc de coefficient (KBi) comportant les éléments suivants :

-- une première unité de multiplication (M1i) et une deuxième unité de multiplication (M2i),

-- une première unité d'addition (A1i) et une deuxième unité d'addition (A2i), une première entrée (E1A1i) de la première unité d'addition (A1i) étant reliée à une sortie (AM1i) de la première unité de multiplication (M1i) et une première entrée (E1A2i) de la deuxième unité d'addition (A2i) étant reliée à une sortie (AM2i) de la deuxième unité de multiplication (M2i),

-- une première unité de retardement (V1i) dont l'entrée (EV1i) est reliée à une sortie (AR1i) d'une première unité de registre (R1i) et dont la sortie (AV1i) est reliée à une première entrée (E1M2i) de la deuxième unité de multiplication (M2i),

-- une deuxième unité de retardement (V2i) dont l'entrée (EV2i) est reliée à une sortie (AA1i) de la première unité d'addition (A1i) et dont la sortie (AV2i) est reliée à une deuxième entrée (E2A2i) de la deuxième unité d'addition (A2i),

-- une troisième unité de retardement (V3i) dont l'entrée (EV3i) est reliée à une sortie (AA2i) de la deuxième unité d'addition (A2i) et dont la sortie (AV3i) est reliée à une deuxième entrée (E2A1i + 1) d'une première unité d'addition (A1i + 1) d'un bloc de coefficient suivant (KBi + 1),

-- une deuxième entrée (E2M1i) de la première unité de multiplication (M1i) et une deuxième entrée (E2M2i) de la deuxième unité de multiplication (M2i), auxquelles est appliqué à chaque fois un mot de coefficient (ci ; i = 1 .. n),

-- la première unité de registre (R1i) qui est reliée par une entrée (ER1i) à une sortie (AR1i + 1) d'une première unité de registre (R1i + 1) d'un bloc de coefficient suivant (KBi + 1),

-- une deuxième unité de registre (R2i) qui est reliée par une entrée (ER2i) à une sortie (AR2i + 1) d'une deuxième unité de registre (R2i + 1) d'un bloc de coefficient suivant (KBi + 1) et qui est reliée par une sortie (AR2i) à une première entrée (E1m1i) de la première unité de multiplication (M1i),

- une unité de totalisation (accu) dont l'entrée est reliée à la sortie (AV3n) de la troisième unité de retardement (V3n) du n-ième bloc de coefficient (KBn), et

- une sortie de circuit qui est reliée à l'unité de totalisation (accu) et de laquelle un mot de sortie peut être prélevé.

7. Circuit selon la revendication 6, dans lequel la première unité de registre (R1i) et la deuxième unité de registre (R2i) ont une largeur de mot de un et une longueur de $\frac{w_m}{2}$ - 1.

8. Circuit selon la revendication 6, dans lequel la première unité de registre (R1i) et la deuxième unité de registre (R2i) ont une largeur de mot de un et une longueur de wm - 1.

9. Circuit d'un filtre d'interpolation (IF) comportant un filtre (F) selon l'une des revendications 1 à 7.

10. Circuit d'un filtre de décimation (DF) comportant un filtre (F) selon l'une des revendications 1 à 7.

11. Circuit d'un filtre complexe (KF) comportant un filtre (F) selon l'une des revendications 1 à 7.

12. Utilisation d'un filtre (F) selon l'une des revendications 1 à 8 en vue de l'utilisation multiple de ce filtre dont le cycle interne est plus rapide d'un multiple entier qu'un cycle externe dans lequel des mots d'entrée ($x_{in}$) doivent se trouver à une sortie (A) du filtre (F),

- selon laquelle il est prévu dans chaque bloc de coefficient (KBi), prévu pour à chaque fois un coefficient ($c_i$), les étapes suivantes :

-- on applique à chaque fois successivement dans le temps pour la durée d'un cycle interne un bit de coefficient de poids pair ($c_i^l$ ; i = 1 .. n ; 1 ∈ 0, 2, 4, 6, .., $w_k$-2) à une deuxième entrée (E2M1i) d'une première cellule de multiplication (M1i),

-- on applique à chaque fois successivement dans le temps pour la durée d'un cycle interne, avec un retard d'une moitié de cycle interne par rapport à l'application du bit de coefficient de poids pair ($c_i^l$ ; i = 1 .. n ; 1 ∈ 0, 2, 4, 6, ..., $w_k$ - 2), un bit de coefficient de poids impair ($c_i^o$ ; i = 1 .. n ; o ∈ 1, 3, 5, 7, ..., $w_k$ - 1) à une deuxième entrée (E2M2i) d'une deuxième cellule de multiplication (M2i),

-- on multiplie à chaque fois le mot d'entrée appliqué ($x_{in}$) par les bits de coefficient appliqués dans la première cellule de multiplication (M1i) et dans la deuxième cellule de multiplication (M2i), et

- selon laquelle des mots partiels produits par les multiplications sont additionnés selon leur poids pour former un mot total.

13. Utilisation selon la revendication 12, selon laquelle l'addition des mots partiels pour chaque coefficient ($c_i$) est effectuée individuellement dans chaque bloc de coefficient (KBi).

**14.** Utilisation selon la revendication 12, selon laquelle l'addition de tous les mots partiels pour tous les coefficients ($c_i$) est effectuée dans une unité de totalisation (accu).

**15.** Utilisation selon l'une des revendications 9 à 14, selon laquelle des coefficients de plusieurs fonctions de filtrage (Hr (z) ; r = 1 .. s) sont appliqués successivement en alternance aux unités de multiplication (M1i ; M2i).

**16.** Utilisation d'un filtre (F) selon l'une des revendications 1 à 8 en vue de l'utilisation multiple de ce filtre dont le cycle interne est plus rapide d'un multiple entier qu'un cycle externe dans lequel des mots d'entrée ($x_{in}$) d'une largeur de mot de données d'entrée (wj ; j = 1 .. m) doivent se trouver à une sortie (A) du filtre (F),

- selon laquelle il est prévu dans chaque bloc de coefficient (KBi), prévu pour à chaque fois un coefficient ($c_i$), les étapes suivantes :

  -- on applique à chaque fois successivement dans le temps pour la durée d'un cycle interne un bit de mot d'entrée de poids pair ($w_j^l$ ; 1 ∈ 0, 2, 4, 6, .., $w_m$ - 2) à une entrée (EV1i) d'une première unité de retardement (V1i),
  -- on applique à chaque fois successivement dans le temps pour la durée d'un cycle interne un bit de mot d'entrée de poids impair ($w_j^o$ ; o ∈ 1, 3, 5, 7, .., $w_m$ - 1) à une première entrée (E1m1i) d'une première cellule de multiplication (M1i),
  -- on multiplie à chaque fois le mot de coefficient (ci) appliqué à une première entrée (E1M1i) d'une première cellule de multiplication (M1i) et le mot de coefficient ($c_i$) appliqué à une première entrée (E1M2i) d'une deuxième cellule de multiplication (M2i), et

- selon laquelle des mots partiels produits par les multiplications sont additionnés selon leur poids dans une unité de totalisation (accu) pour former un mot total.

FIG 1

FIG 2

FIG 3

EP 0 860 051 B1

FIG 4

# F I G 5

X1in

X2in

$C_{2n}$

$C_{1n}$

$z^{-1/2}$

$z^{-1/2}$

$z^{-1/2}$

accu

$W_R$

R1i+1

R2i+1

KBi+1

$C_{2i+1}$

$C_{1i+1}$

$z^{-1/2}$

$z^{-1/2}$

$z^{-1/2}$

R1i

AR1i

R2i

V1i

M2i

M1i

$C_{2i}$

$C_{1i}$

A2i

A1i

V3i

V2i

KBi

$z^{-1/2}$

$z^{-1/2}$

$z^{-1/2}$

FIG 6

H1(z)

Z-1/2

H3(z)

IF

FIG 7

Z-1/2

H1(z)

H2(z)

DF

FIG 8

H1(z)

H2(z)

H3(z)

H4(z)

KF

FIG 9

FIG 10

# FIG 11

1 — anlegen von $c_i^l$ an E2M1i

2 — anlegen von $c_i^o$ an E2M2i verzögert um einen halben inneren Takt

7 — nächstes Eingangswort $x_{in}$

3 — $x_{in}$ wird mit $c_i^l$ und $c_i^o$ multipliziert

6 — $l := l+2$
$o := o+2$

4 — alle $c_i^l$ und $c_i^o$ multipliziert ?

5 — Teilwörter werden aufsummiert

## FIG 12

8
anlegen von $w_j^I$ an EV1i

9
anlegen von $w_j^o$ an E1M1i

14
nächstes Eingangswort $x_{in}$

10
$c_i$ wird mit $w_j^I$ und $w_i^o$ multipliziert

13
$I := I+2$
$o := o+2$

11
alle $w_j^I$ und $w_j^o$ multipliziert ?

12
Teilwörter werden aufsummiert

## FIG 13

```
                          15
            ┌─────────────────────────┐
            │  Möglichkeiten zur       │
            │  Summation der           │
            │  Teilwörter              │
            └─────────────────────────┘
               /                  \
          16  /                    \  17
   ┌──────────────┐          ┌──────────────┐
   │  jeweils in  │          │   in accu    │
   │  einem KBi   │          │              │
   └──────────────┘          └──────────────┘
```